(19) **Europäisches Patentamt / European Patent Office / Office européen des brevets**

(11) **EP 4 582 583 A1**

(12) **EUROPEAN PATENT APPLICATION**
published in accordance with Art. 153(4) EPC

(43) Date of publication:
**09.07.2025 Bulletin 2025/28**

(21) Application number: **23859992.2**

(22) Date of filing: **09.08.2023**

(51) International Patent Classification (IPC):
*C23C 14/34* (2006.01)        *C04B 35/495* (2006.01)
*H10N 30/076* (2023.01)       *H10N 30/097* (2023.01)
*H10N 30/853* (2023.01)

(52) Cooperative Patent Classification (CPC):
**C04B 35/495; C23C 14/34; H10N 30/076; H10N 30/097; H10N 30/853**

(86) International application number:
**PCT/JP2023/029023**

(87) International publication number:
**WO 2024/048225 (07.03.2024 Gazette 2024/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.09.2022 JP 2022139211**

(71) Applicants:
• **Sumitomo Chemical Company, Limited**
  **Tokyo 103-6020 (JP)**
• **Toshima Manufacturing Co., Ltd.**
  **Higashimatsuyama-shi, Saitama 355-0036 (JP)**

(72) Inventors:
• **KURODA, Toshiaki**
  **Hitachi-shi, Ibaraki 319-1418 (JP)**
• **SHIBATA, Kenji**
  **Hitachi-shi, Ibaraki 319-1418 (JP)**
• **WATANABE, Kazutoshi**
  **Hitachi-shi, Ibaraki 319-1418 (JP)**
• **IWATANI, Kosaku**
  **Higashimatsuyama-shi, Saitama 355-0036 (JP)**

(74) Representative: **Vossius & Partner**
**Patentanwälte Rechtsanwälte mbB**
**Siebertstrasse 3**
**81675 München (DE)**

(54) **SPUTTERING TARGET MATERIAL AND METHOD FOR PRODUCING SPUTTERING TARGET MATERIAL**

(57)    A sputtering target material constituted from a sintered ceramics of an oxide containing potassium, sodium, niobium, and oxygen, wherein the sputtering target material has a density of 4.2 g/cm$^3$ or less, a Vickers hardness of 30 or more and 200 or less, and an area-weighted mean grain size of 3.0 μm or more for a plurality of crystal grains observed on a sputtering surface.

**FIG. 1**

EP 4 582 583 A1

## Description

FIELD AND BACKGROUND

The present disclosure relates to a sputtering target material and a method for producing the sputtering target material.

DESCRIPTION OF RELATED ART

There are situations where a sputtering target material constituted from a sintered ceramics of an oxide containing potassium, sodium, niobium, and oxygen (hereinafter also referred to as "KNN target material" or simply as "target material") is used as a material for depositing a piezoelectric thin film (see, for example, Patent document 1).

PRIOR ART DOCUMENT

PATENT DOCUMENT

[Patent Document 1] Japanese Patent Laid Open Publication No. 2011-146623

SUMMARY OF THE INVENTION

PROBLEM TO BE SOLVED BY THE INVENTION

An objective of the present disclosure is to provide a KNN target material with low density and high resistance to fracture.

MEANS FOR SOLVING THE PROBLEM

According to an aspect of the present disclosure, there is provided

a sputtering target material constituted from a sintered ceramics of an oxide containing potassium, sodium, niobium, and oxygen, wherein
the sputtering target material has a density of 4.2 g/cm$^3$ or less,
a Vickers hardness of 30 or more and 200 or less, and
an area-weighted mean grain size of 3.0 $\mu$m or more for a plurality of crystal grains observed on a sputtering surface.

According to another aspect of the present disclosure, there is provided

a method for producing a sputtering target material constituted from a sintered ceramics of an oxide containing potassium, sodium, niobium, and oxygen, the method including:

(a) mixing a raw material powder including a compound containing sodium and a raw material powder including a compound containing niobium at a predetermined ratio and heating same in an oxygen-containing atmosphere to prepare a fired powder containing sodium and niobium;
(b) mixing a raw material powder including a compound containing potassium and a raw material powder including a compound containing niobium at a predetermined ratio and heating same in an oxygen-containing atmosphere to prepare a fired powder containing potassium and niobium;
(c) mixing the fired powder prepared in (a) and the fired powder prepared in (b) at a predetermined ratio and heating (calcinating) same in an oxygen-containing atmosphere to prepare a raw material powder containing potassium, sodium, and niobium; and
(d) applying a predetermined pressure to the fired powder prepared in (c) to form a powder compact while also heating the powder compact to produce a sintered ceramics, wherein

a temperature of heating in (a) is higher than a temperature of heating in (b).

ADVANTAGE

According to the present disclosure, a KNN target material with low density and high resistance to fracture can be provided.

BRIEF DESCRIPTION OF THE DRAWINGS

FIG. 1 is a view illustrating one aspect of a target material of the present disclosure.
FIG. 2 is a schematic view of a sintering apparatus used in the present disclosure.
FIG. 3(a) is a schematic view of a fracture surface of sample 1, and FIG. 3(b) is a photograph of the fracture surface of sample 1.
FIG. 4(a) is a schematic view of a fracture surface of sample 21, and FIG. 4(b) is a photograph of the fracture surface of sample 21.

DETAILED DESCRIPTION

<Findings obtained by the inventors>

A KNN target material (KNN sintered ceramics) is normally prepared in a sintering process based on so-called hot pressing (hereinafter referred to as "hot press sintering"), which involves applying a mechanical pressure to a fired powder (KNN fired powder) containing potassium (K), sodium (Na), niobium (Nb), and oxygen (O) to form a powder compact and simultaneously heating to sinter the powder compact. This is because KNN is a poorly sinterable material, and to promote sintering (sintering reaction) of KNN fired powder at normal pressures, sintering would have to be carried out at extremely high temperatures.

However, hot press sintering is normally carried out in a nitrogen gas atmosphere, inert gas atmosphere (e.g., an atmosphere including an inert gas such as argon or helium), or vacuum to avoid thermally damaging the heater, heat-insulating materials, and other furnace components, and the partial pressure of oxygen in the atmosphere cannot be increased. Therefore, hot press sintering could result in some of the O in KNN fired powder being desorbed. Consequently, the composition of the final resulting KNN target material may deviate from the desired composition. For example, the O composition in the final resulting KNN target material may be less than the desired composition. When sputter deposition is carried out using the KNN target material that deviates in composition in this manner, the composition of the resulting sputtered film (KNN film) may also deviate from the desired composition, compromising the characteristics of the KNN film. For example, the insulating characteristics of the KNN film may worsen, causing larger leakage current.

For this reason, the KNN target material (KNN sintered ceramics) that has been prepared by hot press sintering is heat treated (subjected to an oxidation treatment) in an O-containing atmosphere. This treatment allows the KNN target material, having lost some O from desorption in hot press sintering, to absorb O and allows the final resulting KNN target material to achieve the desired composition.

Furthermore, there is also demand to make the KNN target material less susceptible to fractures, chipping, and other defects while such KNN target material is being prepared (e.g., during the oxidation treatment described above or during griding and other mechanical processes carried out when the KNN target material is being prepared) and also during sputter deposition using the KNN target material. Note that in the present description, the KNN target material less susceptible to fractures, chipping, and other defects will also be referred to as target material with high mechanical strength. Until now, it had been thought that it was effective for the KNN target material to be provided with a high density to improve the mechanical strength of the KNN target material, and it is for this reason that high density KNN target material has traditionally been prepared in hot press sintering.

However, when applying the oxidation treatment described above to high density KNN target material, the heating temperature in the oxidation treatment must be high (e.g., exceeding 1100 °C) in order for enough O to be absorbed into the center of the KNN target material for oxidation to sufficiently reach the center. This will consequently make the KNN target material more susceptible to warping and fractures, decreasing the production yield of the KNN target material. Furthermore, when the heating temperature in oxidation treatment is high, some of the K in the KNN target material is liable to scatter (vaporize) during oxidation treatment. This may also result in a deviation of the composition of the final resulting KNN target material from the desired composition. For example, the K composition in the final resulting KNN target material may be less than the desired composition.

For this reason, it is also conceivable to carry out hot press sintering under low temperature and low pressure conditions and prepare low density KNN target material. When applying the oxidation treatment to low density KNN target material, enough O can be absorbed into the center of the KNN target material for oxidation to sufficiently reach the center even when the heating temperature in the oxidation treatment is low. Furthermore, a low heating temperature in the oxidation treatment will make the KNN target material less susceptible to warping and fractures during the oxidation treatment and can reduce the likelihood of some of the K in the KNN target material vaporizing.

However, the mechanical strength of low density KNN target material tends to be lower than that of high density KNN target material. Low density KNN target material will hence be more susceptible to fractures, chipping, and other defects while such KNN target material is being prepared or during sputter deposition.

The inventors diligently studied the above problems. From these studies, the inventors found that a KNN target material low in density yet highly resistant to fractures could be produced by setting a Vickers hardness to a specific range and setting an area-weighted mean grain size of a plurality of crystal grains observed on the face of the KNN target material that will be used as the sputtering surface to a specific value or larger. In other words, it was found that it was possible to produce the KNN target material which despite being low in density, is less susceptible to fractures, chipping, and other defects during preparation of the KNN target material or sputter deposition.

The present disclosure is based on the above problems and findings determined by the inventors.

<Aspects of the present disclosure>

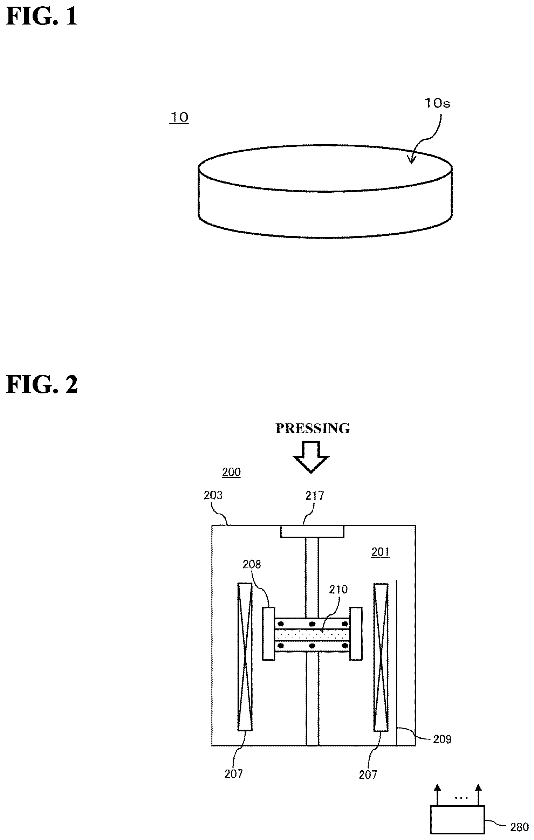

Hereinafter, an aspect of the present disclosure will be described primarily with reference to FIG. 1 and FIG. 2.

(1) Configuration of target material

A target material 10 according to the present aspect is constituted from a sintered ceramics including an oxide (alkali niobium oxide) primarily containing K, Na, Nb, and O, that is, a KNN sintered ceramics. The crystal grains primarily constituting the target material 10 have a perovskite structure. To be specific, the target material 10 is expressed by the composition formula $(K_{1-x}Na_x)NbO_3$ $(0 < x < 1)$, where the coefficient x [= Na/(K+Na)] in the composition formula is $0 < x < 1$, preferably $0.4 \leq x \leq 0.8$. The KNN sintered ceramics constituting the target material 10 is an oxide sintered ceramics substantially composed of K, Na, Nb, and O, or an oxide sintered ceramics further including a dopant element described later. Here, "substantially" including means that 99 % or more of all the atoms constituting the target material 10 are K, Na, Nb, and O, or, K, Na, Nb, O, and the dopant element when the target material 10 contains the dopant element.

The composition of K, Na, and Nb in the target material 10 expressed as $(([K] + [Na])/[Nb])$ is more than 1.0, preferably 1.02 or more, and is preferably 1.10 or less, more preferably 1.07 or less, and even more preferably 1.04 or less.

Here, [K], [Na], and [Nb] in the formula $([K] + [Na])/[Nb]$ represent the molar quantities of the K atoms, Na atoms, and Nb atoms in the target material 10. The composition of the target material 10 can be determined thorough, for example, atomic absorption spectroscopy (AAS) and inductively coupled plasma atomic emission spectroscopy (ICP-AES). That is, the composition of the target material 10 can be determined by determining the molar quantities of the K and Na atoms through AAS (using, for example, Z-2310 manufactured by Hitachi High-Technologies Corporation) and determining the molar quantity of Nb atoms through ICP-AES (using, for example, SPS5000 manufactured by Seiko Instruments Inc.). Note that determining the molar quantities of K and Na atoms solely through ICP-AES or solely through energy dispersive X-ray spectroscopy (EDX) is also conceivable, but the reliability of such measurements is lower due to low measurement sensitivity and poor reproducibility.

At least one element (dopant) selected from the group consisting of copper (Cu) and manganese (Mn) may be added to the target material 10 at a concentration of, for example, 0.1 at% or more and 2.0 at% or less. When both Cu and Mn are added, the total concentration is 0.1 at% or more and 2.0 at% or less. Consequently, at least one element selected from the group consisting of Cu and Mn can be included at a predetermined concentration in a KNN film obtained by sputter deposition using the target material 10.

Note that "adding at least one element selected from the group consisting of Cu and Mn to the target material 10 at a concentration of 0.1 at% or more and 2.0 at% or less" in the description means adding the elements Cu and Mn such that the value of the ratio of the total number of Cu and Mn atoms to the total number of atoms of all elements constituting the target material 10 (= {(number of Cu atoms + number of Mn atoms)/(number of K atoms + number of Na atoms + number of Nb atoms + number of Cu atoms + number of Mn atoms)} $\times$ 100) is 0.1 or more and 2.0 or less.

The target material 10 has, for example, a disk-like shape, and is bonded (attached) on a backing plate, not shown in the drawings, composed of Cu or the like via a bonding material containing indium (In), tin (Sn), or an alloy of either of these metals for use as a sputtering target. Of the two main surfaces of the target material 10, the surface different from the surface bonded to the backing plate is used as the surface to be exposed to a plasma such as argon (Ar) during sputter deposition, that is, a sputtering surface 10s from which the atoms that will constitute the sputtered film (KNN film) are ejected.

When the target material 10 has a disk-like-shape, the diameter of each main surface of the target material 10, preferably the diameter of the sputtering surface 10s, is, for example, 30 mm or more, preferably 75 mm or more, more preferably 90 mm or more, even more preferably 100 mm or more, especially preferably 200 mm or more. The area of each main surface of the target material 10, preferably the area of the sputtering surface 10s, is, for example, 4500 mm$^2$ or more, preferably 5000 mm$^2$ or more, more preferably 6000 mm$^2$ or more, even more preferably 7500 mm$^2$, especially preferably 15000 mm$^2$. Note that the upper limits of the diameter of each main surface of the target material 10 and the area of each main surface of the target material 10 are not particularly limited.

The target material 10 may also have a plate-like shape with rectangular main surfaces, and the length of each main surface of the target material 10 along the long sides, preferably the length of the sputtering surface 10s along the long sides, is, for example, 80 mm or more, preferably 100 mm or more, more preferably 120 mm or more, even more preferably 150 mm or more, especially preferably 200 mm or more. The length of each main surface of the target material 10 along the short sides, preferably the length of the sputtering surface 10s along the short sides, is, for example, 50 mm or more, preferably 80 mm or more, more preferably 100 mm or more. The area of each main surface of the target material 10, preferably the area of the sputtering surface 10s, is, for example 4500 $mm^2$ or more, preferably 5000 $mm^2$ or more, more preferably 6000 $mm^2$ or more, even more preferably 7500 $mm^2$ or more, especially preferably 15000 $mm^2$ or more. Note that the length of each main surface of the target material 10 along the long sides and along the short sides and the upper limit of the area of each main surface of the target material 10 are not particularly limited.

The thickness of the target material 10 is, for example, 2 mm or more, preferably 3 mm or more, more preferably 5 mm or more, even more preferably 7.5 mm or more, and is preferably 25 mm or less, more preferably 20 mm or less, even more preferably 15 mm or less.

The backing plate is composed of a conductive material including a metal or alloy thereof, examples of which include Cu, Cu alloy, aluminum (Al), Al alloy, titanium (Ti), and stainless steel (SUS). The size of the backing plate is not particularly limited, so long that the backing plate can be bonded to and support the target material 10 and can be set in a sputtering apparatus and so long that the backing plate can function as a cooling plate of the target material 10 and as a sputtering electrode.

Here, "target material 10 with high resistance to fracture" in the description means a target material 10 less susceptible to fractures, chipping, and other defects while the target material 10 is being prepared (e.g., during the oxidation treatment described later or during griding and other mechanical processes), or a target material 10 less susceptible to fractures (cracks) and other defects that would lead to abnormal discharge during sputter deposition using the target material 10. Note that low density target materials are typically weak to fractures and considered to be susceptible to fractures, chipping, and other defects while the target material 10 is being prepared or during sputter deposition.

The target material 10 according to the present aspect is provided with all three of the characteristics of having a density of 4.2 $g/cm^3$ or less, having a Vickers hardness of 30 or more and 200 or less, and having an area-weighted mean grain size (hereinafter also referred to as "area-weighted mean grain size Nv") of 3.0 $\mu$m or more for a plurality of crystal grains observed at the sputtering surface 10s, preferably the sputtering surface 10s and a cross section taken parallel to the sputtering surface 10s. By having these characteristics, the target material 10 with low density and high resistance to fracture can be produced.

A density of 4.2 $g/cm^3$ or less for the target material 10 allows enough oxygen (O) to be absorbed into the center of the target material 10 for oxidation to sufficiently reach the center of the target material 10 even when the heating temperature in the oxidation treatment (step E) described later is low. This allows the target material 10 to be produced with the desired O composition throughout its entire structure (throughout its entire structure in the thickness direction and in-plane direction).

Furthermore, a density of 4.2 $g/cm^3$ or less for the target material 10 allows the target material 10 to be produced under a low heating temperature in the oxidation treatment described later. Therefore, the likelihood of some of the potassium (K) (K component) in the target material 10 vaporizing during oxidation treatment can be reduced. This allows the target material 10 to be produced with the desired K composition throughout its entire structure.

Thus, a density of 4.2 $g/cm^3$ or less for the target material 10 allows the target material 10 to be produced with the desired O and K composition throughout its entire structure. In turn, this can ensure that a KNN film with predetermined physical properties (crystal quality, thickness, composition, etc.) and predetermined characteristics (piezoelectric characteristics, insulating characteristics, etc.) can be produced by sputter deposition using the target material 10. That is, a highly reliable KNN film can be produced.

Furthermore, a density of 4.2 $g/cm^3$ or less for the target material 10 allows the target material 10 to be produced under a low heating temperature in the oxidation treatment described later. Therefore, the target material 10 can be made less susceptible to warping and fractures during oxidation treatment, increasing production yield of the target material 10.

The density of the target material 10 is preferably 4.0 $g/cm^3$ or less. This can ensure that oxidation reaches the center of the target material 10 even when the heating temperature in the oxidation treatment is set to a low temperature in the manner described later. This in turn can ensure that the target material 10 is produced with the desired O and K composition throughout its entire structure.

When the density of the target material 10 exceeds 4.2 $g/cm^3$, oxidation may not sufficiently reach the center of the target material 10 should the heating temperature in the oxidation treatment be set to a low temperature in the manner described later. Therefore, the O composition may deviate from the desired composition, particularly at the center of the target material 10.

Furthermore, when the density of the target material 10 exceeds 4.2 $g/cm^3$, a high heating temperature in the oxidation treatment allows oxidation to sufficiently reach the center of the target material 10. However, while a high heating temperature in the oxidation treatment allows oxidation to sufficiently reach the center of the target material 10, there is a greater likelihood that some of the K component in the target material 10 vaporize during the oxidation treatment. Therefore, the target material 10 with a density exceeding 4.2 g/cm$^3$ may have a K composition deviating from the desired composition. Furthermore, when the heating temperature in the oxidation treatment is high, the target material 10 will be more susceptible to warping and fractures during the oxidation treatment.

Furthermore, the density of the target material 10 is preferably 3.5 g/cm$^3$ or more. This can ensure that the target material 10 is produced with low density and high resistance. When the density of the target material 10 is less than 3.5 g/cm$^3$, the mechanical strength of the target material 10 may be insufficient even with a Vickers hardness of 30 or more and 200 or less and an area-weighted mean grain size Nv of 3.0 μm or more. Consequently, the target material 10 with low density and high resistance to fracture may not be produced.

The density of the target material 10 can be measured using, for example, the device and method described below. Below is an example of a method for measuring density.

[Density measurement method]

Device: Electronic densimeter MDS300 manufactured by Alfa Mirage Co., Ltd.

Test method: Each piece of target material cut into a predetermined size is measured in density, using the above device, based on Archimedes' Principle.

The Vickers hardness of the target material 10 according to the present aspect is 30 or more and 200 or less, preferably 30 or more and less than 200, more preferably 30 or more and less than 150. This allows the target material 10 to be produced with low density and high resistance to fracture.

When the Vickers hardness of the target material 10 is less than 30, the mechanical strength of the target material 10 may be insufficient even with the area-weighted mean grain size Nv of 3.0 μm or more. In turn, the target material 10 may not be produced with low density and high resistance to fracture.

When the Vickers hardness of the target material 10 exceeds 200, the target material 10 may not be produced with low density and high resistance to fracture. This is because to produce the target material 10 with a Vickers hardness exceeding 200, the pressure applied in the hot press sintering process (step D) described later (sintering pressure described later) must exceed 500 kgf/cm$^2$. Consequently, the density of the target material 10 may exceed 4.2 g/cm$^3$. Furthermore, a temperature exceeding 1150 °C for the hot press sintering described later (sintering temperature described later) is also conceivable for producing the target material 10 with a Vickers hardness exceeding 200. In this case, the K component may deviate from the desired composition since the K component is liable to vaporize during hot press sintering.

The Vickers hardness (Hv) of the target material 10 can be measured with a Vickers hardness tester according to JIS R 1610:2003. Below is an example of a method for measuring the Vickers hardness and the measurement conditions therefor.

[Vickers hardness measurement method and measurement conditions]

    Device: Micro Vickers hardness tester HM-114 manufactured by Mitutoyo Corporation
    Atmosphere: air
    Temperature: room temperature (25 °C)
    Test force: 1.0 kgf
    Load applying speed: 10 μm/s
    Dwell time: 15 sec
    Number of measurement points: 5 points

Test method: This test conforms to JIS R 1610 and involves using a Vickers indenter (a square base pyramid indenter with an angle of 136 degrees between opposing sides) to determine the Vickers hardness from the test force at the time an indent is made on the test surface and the surface area of the indent as determined from the length of the diagonal of the indent and averaging the measurement results at five points.

Furthermore, the area-weighted mean grain size Nv of the target material 10 according to the present aspect is 3.0 μm or more. Since the Vickers hardness of the target material 10 is within a predetermined range and the target material 10 is constituted from crystal grains with a large mean grain size, the mechanical strength of the target material 10 can be increased. This allows the target material 10 to be produced with low density and high resistance to fracture.

The area-weighted mean grain size Nv of the target material 10 is preferably 5.0 μm or more. This can ensure that the mechanical strength of the target material 10 can be increased.

When the area-weighted mean grain size Nv of the target material 10 is less than 3.0 μm, the mechanical strength of the target material 10 cannot be increased while retaining a low density, and the target material 10 will be more susceptible to fractures, chipping and other defects while the target material 10 is being prepared or during sputter deposition. That is, the target material 10 may not be produced with low density and high resistance to fracture.

The area-weighted mean grain size Nv (μm) can be determined by, among other things, an analysis of an electron back scattered diffraction pattern (EBSD) image of the sputtering surface 10s of the target material 10 or a cross section taken parallel to the sputtering surface 10s. The crystal grain size determined from the EBSD analysis denotes the diameter of a circle having the same area as a measured crystal grain, and the area-weighted mean grain size Nv (μm) can be the mean grain size determined based on the area fraction method. In the area fraction method, the total of the values obtained by multiplying the area of each crystal grain by the fraction of the total area that the area of the each crystal grain occupies is the mean area of the crystal grains, and the diameter of the calculated area when assumed to be a circle is the mean grain size. Note that in EBSD analysis, the area-weighted mean grain size Nv (μm) can be determined by treating boundaries with a crystal grain misorientation of a certain value or higher, e.g., 15 degrees or higher, as crystal grain boundaries.

Furthermore, the area-weighted mean grain size Nv (μm) can be a value calculated using the formula below. In the formula below, $d_i$ is the grain size (μm) of an observed crystal grain, and $n_i$ is the observed number of crystal grains having grain size $d_i$ (μm). $d_i$ is the diameter of a true circle having an area equivalent to the area of the observed crystal grain, that is, an equivalent circular diameter (μm).

$$\text{Area-weighted mean grain size Nv (μm)} = \Sigma(d_i^3 \times n_i)/\Sigma(d_i^2 \times n_i)$$

The area-weighted mean grain size Nv (μm) is a mean value that is weighted according to the size of the grain area.

More details will be provided later, but the target material 10 according to the present aspect is prepared by hot press sintering a fired powder (KNN fired powder) containing K, Na, Nb, and O under predetermined conditions. Furthermore, in the preparation of the KNN fired powder, a raw material powder containing Na and a raw material powder containing Nb are mixed and fired to prepare a fired powder containing Na and Nb ($NaNbO_3$ powder), a raw material powder containing K and a raw material powder containing Nb are mixed and fired to prepare a fired powder containing K and Nb ($KNbO_3$ powder), and the prepared $NaNbO_3$ powder and $KNbO_3$ powder are mixed and fired to prepare the KNN fired powder. Furthermore, in the preparation of the $NaNbO_3$ powder and $KNbO_3$ powder, the $NaNbO_3$ powder and $KNbO_3$ powder are respectively prepared such that the firing temperature for preparing the $NaNbO_3$ powder is higher than the firing temperature for preparing producing the $KNbO_3$ powder.

The target material 10 according to the present aspect is prepared by hot press sintering the KNN fired powder prepared by the above technique. For this reason, the target material 10 according to the present aspect can be provided with all three of the characteristics of having a density of 4.2 g/cm³ or less, having a Vickers hardness of 30 or more and 200 or less, and having an area-weighted mean grain size Nv of 3.0 μm or more.

Furthermore, the target material 10 according to the present aspect is prepared using the KNN fired powder prepared by the above technique, and consequently the target material 10 according to the present aspect can be further provided with the characteristic of the plurality of crystal grains observed at the sputtering surface 10s, preferably the sputtering surface 10s and a cross section taken parallel to the sputtering surface 10s, primarily including a plurality of crystal grains composed of an oxide containing Na and Nb ($NaNbO_3$ grains) and a plurality of crystal grains composed of an oxide containing K and Nb ($KNbO_3$ grains). By identifying the portions where Na and Nb for the $NaNbO_3$ grains and K and Nb for the $KNbO_3$ grains are detected through scanning electron microscope-energy dispersive X-ray spectrometry (SEM-EDX), it can be seen that the plurality of crystal grains observed at the sputtering surface 10s primarily include $NaNbO_3$ grains and $KNbO_3$ grains.

Furthermore, the target material 10 is prepared using the KNN fired powder prepared by the novel technique described above, and consequently the target material 10 according to the present aspect can be further provided with the characteristic of portions of high Na content (hereinafter Na-rich portions) and portions of high K content (hereinafter K-rich portions) being present (scattered) on the sputtering surface 10s, preferably the sputtering surface 10s and a cross section taken parallel to the sputtering surface 10s. Na-rich portions are portions with a higher Na concentration than the mean Na concentration in the target material 10, and K-rich portions are portions with a higher K concentration than the mean K concentration in the target material 10. Furthermore, when observing the sputtering surface 10s and a cross section taken parallel to the sputtering surface 10s through energy dispersive X-ray spectroscopy (EDX) or SEM-EDX, it can be seen that Na-rich portions and K-rich portions are present on the sputtering surface 10s, preferably the sputtering surface 10s and a cross section taken parallel to the sputtering surface 10s.

(2) Method for producing target material

A preferred embodiment of a method for preparing the target material 10 according to the present aspect will be described in detail with reference to FIG. 2.

The sequence for preparing the target material 10 according to the present aspect involves:

a step (step A) of mixing a raw material powder including a compound containing Na and a raw material powder including a compound containing Nb at a predetermined ratio and heating same (the powder mixture) in an oxygen-containing atmosphere to prepare a fired powder containing Na and Nb;

a step (step B) of mixing a raw material powder including a compound containing K and a raw material powder including a compound containing Nb at a predetermined ratio and heating same (the powder mixture) in an oxygen-containing atmosphere to prepare a fired powder containing K and Nb;

a step (step C) of mixing the fired powder prepared in step A and the fired powder prepared in step B at a predetermined ratio and heating (calcinating) same (the powder mixture) in an oxygen-containing atmosphere to prepare a fired powder containing K, Na, and Nb; and

a step (step D) of applying a predetermined pressure to the fired powder prepared in step C to form a powder compact while also (simultaneously) heating the powder compact to producem a sintered ceramics.

Furthermore, in the sequence for preparing the target material 10 according to the present aspect, the heating temperature in step A is higher than the heating temperature in step B.

Furthermore, in step C, the fired powder prepared in step A, the fired powder prepared in step B, and a powder containing at least one element selected from Cu and Mn may be mixed at a predetermined ratio to prepare a fired powder containing K, Na, and Nb and at least one element selected from Cu and Mn as a dopant.

Furthermore, after step D, a heat treatment is further applied to the sintered ceramics in an oxygen-containing atmosphere for one hour or more at a heating temperature of 500 °C or more and 1100 °C or less (step E).

<Step A: Preparation of fired powder containing Na and Nb>

In this step, a raw material powder including a compound containing Na and a raw material powder including a compound containing Nb are mixed at a predetermined ratio, and the resulting powder mixture is heated in an oxygen-containing atmosphere to prepare (create) a fired powder containing Na and Nb.

(Preparation of starting material powder)

First, a powder including a compound containing Na and a powder including a compound containing Nb are prepared as starting material powders for this step. For example, sodium carbonate ($Na_2CO_3$) powder and niobium pentoxide ($Nb_2O_5$) powder are prepared.

"Powder including a compound containing Na" refers to a powder including a compound of Na as a main component and includes not only powders solely containing a compound of Na, but also powders containing a compound of Na as a main component and another compound. Likewise, "powder including a compound containing Nb" refers to a powder including a compound of Nb as a main component and includes not only powders solely containing a compound of Nb, but also powders containing a compound of Nb as a main component and another compound. A compound of Na refers to at least one compound selected from the group consisting of an oxide of Na, a composite oxide of Na, and a compound of Na that becomes an oxide when heated, examples being, carbonate, as described above, and oxalate. A compound of Nb refers to at least one compound selected from the group consisting of an oxide of Nb, a composite oxide of Nb, and a compound of Nb that becomes an oxide when heated, an example being niobium pentoxide, as described above.

The mean particle size of the secondary particles of these starting material powders is preferably less than 1 mm, for example, and the starting material powders are preferably coarsely milled in advance before weighing as necessary.

(Weighing and mixing)

Next, the $Na_2CO_3$ powder and $Nb_2O_5$ powder used as the starting material powders are weighed, and the mixing ratio of the $Na_2CO_3$ powder and $Nb_2O_5$ powder is adjusted such that the resulting fired powder containing Na and Nb has the desired composition. The weighing process may be performed in an air atmosphere, but would preferably be performed in an inert gas atmosphere, vacuum, dry air atmosphere, or other low humidity atmosphere, and also performed preferably after the $Na_2CO_3$ powder and $Nb_2O_5$ powder have been sufficiently dried. Then, the weighed $Na_2CO_3$ powder and $Nb_2O_5$ powder are dry-mixed or wet-mixed by a mixer, such as a Henschel mixer, a blender, a ribbon mixer, a super mixer, a Nauta mixer, an intensive mixer, a ball mill, or an automatic mortar and pestle.

(primary firing)

A primary firing process is carried out on the resulting powder mixture of the $Na_2CO_3$ powder and $Nb_2O_5$ powder by means of an electric furnace or other such furnace in an air atmosphere, oxygen gas atmosphere, or other oxygen (O)-containing atmosphere (oxidizing atmosphere) to produce a fired powder containing Na and Nb ($NaNbO_3$ powder). Preferably, the powder mixture of the $Na_2CO_3$ powder and $Nb_2O_5$ powder undergoes a solid phase reaction through the primary firing process, producing the $NaNbO_3$ powder containing a solid solution of Na and Nb.

The inventors found that increasing the heating temperature of the primary firing process carried out on the powder mixture of the $Na_2CO_3$ powder and $Nb_2O_5$ powder (hereinafter also referred to as "primary firing temperature A") can increase the mean particle size of the primary particles of the resulting $NaNbO_3$ powder (mean primary particle size). Note that even when primary firing temperature A is high, the Na and Nb will virtually not vaporize while the $NaNbO_3$ powder is being prepared. Increasing the mean primary particle size of the $NaNbO_3$ powder facilitates production of the target material 10 with the area-weighted mean grain size Nv of 3.0 $\mu$m or more. Note that "mean primary particle size of $NaNbO_3$ powder" in the description means the median diameter $D_{50}$ of primary particles in $NaNbO_3$ powder calculated, by reading, from a scanning electron microscope (SEM) image observed at 2000 to 5000 times magnification. Furthermore, "primary particles" in the description means individual particles.

Primary firing temperature A is higher than primary firing temperature B in step B described later. Preferably, primary firing temperature A is a temperature at which the mean primary particle size of $NaNbO_3$ powder becomes larger than the mean primary particle size of $KNbO_3$ powder prepared in step B. Since the mean primary particle size of the $NaNbO_3$ powder becomes larger by increasing primary firing temperature A in this manner, it is easier to make the mean primary particle size of the $NaNbO_3$ powder larger than the mean primary particle size of the $KNbO_3$ powder described later. Preparing the $NaNbO_3$ powder with a large mean primary particle size in this step also make it easier to increase the mean primary particle size of the KNN fired powder produced in step C described later. Therefore, it is also easier to increase the mean size of the crystal grains constituting the final resulting target material 10. Consequently, it is easier to produce the target material 10 with the characteristic of having the area-weighted mean grain size Nv of 3.0 $\mu$m or more.

Preferably, primary firing temperature A is a temperature at which the mean primary particle size of the $NaNbO_3$ powder becomes larger than the mean primary particle size of the $KNbO_3$ powder described later. More preferably, primary firing temperature A is a temperature at which the mean primary particle size of the $NaNbO_3$ powder becomes 5.0 $\mu$m or more, for example. Preparing the $NaNbO_3$ powder in this step with a mean primary particle size larger than the mean primary particle size of the $KNbO_3$ powder described later, for example, preparing the $NaNbO_3$ powder with a mean primary particle size of 5.0 $\mu$m or more, can ensure that the target material 10 with the characteristic of having the area-weighted mean grain size Nv of 3.0 $\mu$m or more can be produced.

Primary firing temperature A is preferably 1000 °C or higher. This allows for the $NaNbO_3$ powder with a large mean primary particle size, for example, a mean primary particle size of 5.0 $\mu$m or more. From the viewpoint of ensuring that the $NaNbO_3$ powder with a large mean primary particle size can be produced, primary firing temperature A is more preferably 1100 °C or higher. Note that when primary firing temperature A is less than 1000 °C, the mean primary particle size of the $NaNbO_3$ powder, that is, the primary particles of the $NaNbO_3$ powder, may not become large enough.

The upper limit of primary firing temperature A is not particularly limited, but an upper limit of 1300 °C or lower is preferable. When primary firing temperature A exceeds 1300 °C, not only will the effect of increasing the mean primary particle size of the $NaNbO_3$ powder saturate, but production costs for $NaNbO_3$ powder may increase. Primary firing temperature A is preferably 1250 °C or lower, more preferably 1200 °C or lower, from the viewpoint of reliably avoiding increases in $NaNbO_3$ production costs.

The duration of the primary firing process in this step is not particularly limited, but is preferably 3 hours or more and 20 hours or less, more preferably 4 hours or more and 15 hours or less, even more preferably 5 hours or more and 10 hours or less.

(Coarse milling)

Next, secondary particles of the resulting $NaNbO_3$ powder may be coarsely milled using a ball mill, bead mill, vibration mill, attritor, jet mill, atomizer, cutter mill, or other milling means as necessary. Note that secondary particles are agglomerates constituted from agglomerated primary particles. Furthermore, the purpose of coarse milling is to reduce the size of the secondary particles of the $NaNbO_3$ powder, and coarse milling is carried out under conditions in which the mean primary particle size of the $NaNbO_3$ powder will not decrease (will not change).

Note that the primary firing and coarse milling processes described above can be repeated partially or fully as necessary and that coarse milling can be omitted. Furthermore, a sieving process or the like may be added after these processes are finished or in the interval between these processes. The means for mixing and milling are not limited to the examples described above and can be selected from a wide range of other milling means, and the conditions for such means may also be flexibly selected to meet the specifications described above.

<Step B: Preparation of fired powder containing K and Nb>

In this step, a raw material powder including a compound containing K and a raw material powder including a compound containing Nb are mixed at a predetermined ratio, and the resulting powder mixture is heated in an O-containing atmosphere to prepare (create) a fired powder containing K and Nb.

(Preparation of starting material powder)

First, a powder including a compound containing K and a powder including a compound containing Nb are prepared as starting material powders for this step. For example, potassium carbonate ($K_2CO_3$) powder and $Nb_2O_5$ powder are prepared.

Note that "powder including a compound containing K" refers to a powder including a compound of K as a main component and includes not only powders solely containing a compound of K, but also powders containing a compound of K as a main component and another compound. A compound of K refers to at least one compound selected from the group consisting of an oxide of K, a composite oxide of K, and a compound of K that becomes an oxide when heated, examples being carbonate, as described above, and oxalate.

The mean particle size of the secondary particles of these starting material powders is preferably less than 1 mm, for example, and the starting material powders are preferably coarsely milled in advance before weighing as necessary.

(Weighing and mixing)

Next, the $K_2CO_3$ powder and $Nb_2O_5$ powder used as the starting material powders are weighed, and the mixing ratio of the $K_2CO_3$ powder and $Nb_2O_5$ powder is adjusted such that the resulting fired powder containing K and Nb has the desired composition. The weighing process may be performed in an air atmosphere, but would preferably be performed in an inert gas atmosphere, vacuum, dry atmosphere, or other low humidity atmosphere, and also performed preferably after the $K_2CO_3$ powder and $Nb_2O_5$ powder have been sufficiently dried.

The inventors found that the mean primary particle size of the fired powder containing K and Nb ($KNbO_3$ powder) prepared in this step can be adjusted by adjusting the mixing ratio of the $K_2CO_3$ powder and $Nb_2O_5$ powder. This is a new finding made for the first time by the inventors. By preparing the $KNbO_3$ powder with a large mean primary particle size in this step, a large mean primary particle size can be ensured for the KNN fired powder produced in step C described later. This can ensure that the mean grain size of the crystal grains constituting the final resulting target material 10 can be large. Consequently, this can ensure that the target material 10 with the characteristic of having the area-weighted mean grain size Nv of 3.0 $\mu$m or more can be produced. Note that "mean primary particle size of $KNbO_3$ powder" in the description means the median diameter $D_{50}$ of the primary particles in $KNbO_3$ powder calculated, by reading, from a scanning electron microscope (SEM) image observed at 2000 to 5000 times magnification.

Preferably, the mixing ratio of the $K_2CO_3$ powder and $Nb_2O_5$ powder is adjusted such that the mean primary particle size of the $KNbO_3$ powder becomes, for example, 3.0 $\mu$m or more. Preparing the $KNbO_3$ powder with a mean primary particle size of, for example, 3.0 $\mu$m or more, more preferably 5.0 $\mu$m or more, can better ensure the target material 10 with the characteristic of having the area-weighted mean grain size Nv of 3.0 $\mu$m or more.

Preferably, the mixing ratio of the $K_2CO_3$ powder and $Nb_2O_5$ powder is adjusted such that the composition of the $KNbO_3$ powder becomes K-rich. This can ensure that the $KNbO_3$ powder having a large mean primary particle size, for example, a mean primary particle size of 3.0 $\mu$m or larger, can be produced. A new finding made for the first time by the inventors is that adjusting the mixing ratio of the $K_2CO_3$ powder and $Nb_2O_5$ powder such that the composition of the prepared $KNbO_3$ powder becomes K-rich could ensure a large mean primary particle size for the $KNbO_3$ powder. Here, "K-rich composition" means that the proportion of the K composition in the total composition of the $KNbO_3$ powder (= K composition/total composition of $KNbO_3$ powder) is higher than the proportion of the Nb composition in the total composition of the $KNbO_3$ powder (= Nb composition/total composition of $KNbO_3$ powder).

Preferably, the mixing ratio of the $K_2CO_3$ powder and $Nb_2O_5$ powder is adjusted such that the ratio of the K composition to the Nb composition (hereinafter K/Nb ratio) in the prepared $KNbO_3$ powder is, for example, 1.005 or more, preferably 1.010 or more, more preferably 1.015 or more. This can better ensure that the $KNbO_3$ powder can be produced with a large mean primary particle size, for example, a mean primary particle size of 3.0 $\mu$m or more. Furthermore, preferably, the mixing ratio of the $K_2CO_3$ powder and $Nb_2O_5$ powder is adjusted such that the K/Nb ratio is 1.1 or less, more preferably 1.08 or less. This prevents the inclusion of crystals with crystallographic structures other than perovskite structure in the prepared $KNbO_3$ powder. When there are crystals with crystallographic structures other than perovskite structure in the $KNbO_3$ powder, these crystals may adversely affect the sintering reaction and growth of crystal grains in the hot press sintering process (step D) described later.

Next, a powder mixture of the weighed $K_2CO_3$ powder and $Nb_2O_5$ powder is dry-mixed or wet-mixed by a mixer, such as a Henschel mixer, a blender, a ribbon mixer, a super mixer, a Nauta mixer, an intensive mixer, a ball mill, or an automatic mortar and pestle.

(primary firing)

A primary firing process is carried out on the resulting powder mixture of the $K_2CO_3$ powder and $Nb_2O_5$ powder by means of an electric furnace or other such furnace in an O-containing atmosphere to produce a fired powder containing K and Nb ($KNbO_3$ powder). Preferably, the powder mixture of the $K_2CO_3$ powder and $Nb_2O_5$ powder undergoes a solid phase reaction through the primary firing process, producing the $KNbO_3$ powder containing a solid solution of K and Nb.

The heating temperature of the primary firing process carried out on the powder mixture of the $K_2CO_3$ powder and $Nb_2O_5$ powder (hereinafter also referred to as "primary firing temperature B") is lower than primary firing temperature A described above.

Primary firing temperature B is preferably less than 1000 °C, more preferably 900 °C or lower, even more preferably 800 °C or lower, from the viewpoint of producing the $KNbO_3$ powder with the desired composition. When primary firing temperature B is 1000 °C or higher, some of the K in the $KNbO_3$ powder is liable to vaporize during primary firing. Therefore, the K composition in the $KNbO_3$ powder may deviate from the desired composition. Consequently, the K composition in the final resulting target material 10 may also deviate from the desired composition.

Furthermore, from the viewpoint of ensuring that the $KNbO_3$ powder with a large mean primary particle size, for example, a mean particle size of 3.0 $\mu$m or more, can be prepared, primary firing temperature B is preferably 500 °C or higher, more preferably 600 °C or higher, even more preferably 650 °C or higher, especially preferably 700 °C or higher. When primary firing temperature B is less than 500 °C, the mean primary particle size of the $KNbO_3$ powder, that is, the primary particles of the $KNbO_3$ powder, may not become large enough even when the mixing ratio of $K_2CO_3$ powder and $Nb_2O_5$ powder is adjusted.

The duration of the primary firing process in this step is not particularly limited, but is preferably 3 hours or more and 20 hours or less, more preferably 4 hours or more and 15 hours or less, even more preferably 5 hours or more and 10 hours or less.

(Coarse milling)

Next, secondary particles of the resulting $KNbO_3$ powder may be coarsely milled using a ball mill, bead mill, vibration mill, attritor, jet mill, atomizer, cutter mill, or other milling means as necessary. Note that the purpose of coarse milling is to reduce the size of the secondary particles of the $KNbO_3$ powder, and coarse milling is carried out under conditions in which the mean primary particle size of the $KNbO_3$ powder will not decrease.

Note that the primary firing and coarse milling processes described above can be repeated partially or fully as necessary and that coarse milling can be omitted. Furthermore, a sieving process or the like may be added after these processes are finished or in the interval between these processes. The means for mixing and milling are not limited to the examples described above and can be selected from a wide range of other milling means, and the conditions for such means may also be flexibly selected to meet the specifications described above.

<Step C: Preparation of fired powder containing K, Na, and Nb>

Next, the $NaNbO_3$ powder prepared in step A and the $KNbO_3$ powder prepared in step B are mixed at a predetermined ratio, and the resulting powder mixture is heated in an O-containing atmosphere to prepare a fired powder containing K, Na, Nb, and O (KNN fired powder).

(Preparation of starting material powder)

First, the $NaNbO_3$ powder prepared in step A and the $KNbO_3$ powder prepared in step B are prepared as starting material powders for this step. Furthermore, as necessary, a powder containing at least one dopant element selected from the group consisting of Cu and Mn, for example, a powder of that element in its pure form, an oxide powder containing that element, a composite oxide powder containing that element, or a powder of a compound containing that element that becomes an oxide when heated (e.g., carbonate, oxalate), is prepared as a starting material powder for this step.

The mean particle size of the secondary particles of these starting material powders is preferably less than 1 mm, for example, and the starting material powders are preferably coarsely milled in advance before weighing as necessary.

(Weighing and mixing)

Next, the NaNbO$_3$ powder and KNbO$_3$ powder are weighed, and the mixing ratio of the NaNbO$_3$ powder and KNbO$_3$ powder is adjusted such that the final resulting target material 10 will have the desired composition. The weighing process may be performed in an air atmosphere, but would preferably be performed in an inert gas atmosphere, vacuum, dry air atmosphere, or other low humidity atmosphere, and also performed preferably after the NaNbO$_3$ powder and KNbO$_3$ powder have been sufficiently dried. Then, a powder mixture of the weighed NaNbO$_3$ powder and KNbO$_3$ powder is dry-mixed or wet-mixed by a mixer, such as a Henschel mixer, a blender, a ribbon mixer, a super mixer, a Nauta mixer, an intensive mixer, or an automatic mortar and pestle. Note that the NaNbO$_3$ powder with a large mean primary particle size and the KNbO$_3$ powder with a large mean primary particle size are used as starting material powders in this step. Therefore, the mean primary particle size of the KNN powder mixture can be kept to, for example, 3.0 $\mu$m or more even when sufficiently mixed. Note that "mean primary particle size of the KNN powder mixture" in the description means the median diameter D$_{50}$ of primary particles in the KNN powder mixture calculated, by reading, from an SEM image observed at 2000 to 5000 times magnification.

(Coarse milling)

Next, the powder mixture of the NaNbO$_3$ powder and KNbO$_3$ powder is coarsely milled using a ball mill, bead mill, vibration mill, attritor, jet mill, atomizer, cutter mill, or other milling means as necessary to produce a powder mixture containing K, Na, and Nb (hereinafter KNN powder mixture). The purpose of coarse milling is to reduce the size of the secondary particles of the NaNbO$_3$ powder and KNbO$_3$ powder and is carried out under conditions in which the mean primary particle size of the KNN powder mixture powder after coarse milling will not decrease.

(Calcination and coarse milling)

The resulting KNN powder mixture is calcined by means of an electric furnace or other such furnace in an O-containing atmosphere. The calcination process is able to remove moisture, carbon component, chlorine, and other impurities from the KNN powder mixture and produce a high purity KNN calcined powder ((K, Na)NbO$_3$ powder, hereinafter KNN fired powder).

The heating temperature for calcination (hereinafter, calcination temperature) is preferably 500 °C or higher, more preferably 600 °C or higher, even more preferably 650 °C or higher, especially preferably 700 °C or higher, from the viewpoint of preparing a high purity KNN fired powder. Furthermore, the calcination temperature is preferably 1100 °C or lower, more preferably 1000 °C or lower, more preferably 900 °C or lower, especially preferably 800 °C or lower, from the viewpoint of mitigating vaporization of the K in the KNN powder mixture and producing a KNN fired powder with the desired composition.

The duration of the heating in calcination is not particularly limited, but is preferably 1 hour or more and 50 hours or less, more preferably 3.5 hours or more and 40 hours or less, even more preferably 4 hours or more and 30 hours or less, especially preferably 5 hours or more and 12 hours or less.

The calcination step may be carried out in the form of multiple stages of heat treatment at different calcination temperatures from the viewpoint of easily removing impurities.

After calcination, the powder is coarsely milled using a ball mill, bead mill, vibration mill, attritor, jet mill, atomizer, cutter mill, or other milling means as necessary. The coarse milling is carried out under conditions in which the secondary particles of the KNN fired powder after coarse milling become smaller.

(Fine milling)

The KNN fired powder after coarse milling may be further milled using a ball mill, a bead mill, a vibration mill, an attritor, an atomizer, a jet mill or other milling means, preferably with a jet mill. Fine milling is carried out under conditions in which the mean primary particle size of the KNN fired powder after fine milling is kept at, for example, 3.0 $\mu$m or more. Note that "mean primary particle size of KNN fired powder" in the description means the median diameter D$_{50}$ of primary particles in the KNN fired powder calculated, by reading, from an SEM image observed at 2000 to 5000 times magnification.

It is through the above processes that the KNN fired powder used in hot press sintering according to the present aspect is produced. Since the NaNbO$_3$ powder with a large mean primary particle size and the KNbO$_3$ powder with a large mean primary particle size are used as starting material powders in this step as described above, a KNN fired powder with a large mean primary particle size, for example, a mean primary particle size of 3.0 $\mu$m more, can be produced even when mixing, coarse milling, and fine milling are carried out in the above manner. Furthermore, the resulting KNN fired powder will be used after being additionally heated and dried, as necessary, under 180 to 200 °C conditions, for example.

Note that the calcination, coarse milling, and fine milling processes described above can be repeated partially or fully as necessary and that any of these processes can be omitted. Furthermore, a sieving process or the like may be added after these processes are finished or in the interval between these processes. The means for mixing and milling are not limited to the examples described above and can be selected from a wide range of other milling means, and the conditions for such means may also be flexibly selected to meet the specifications described above.

<Step D: Hot press sintering>

In this step, a KNN sintered ceramics is produced by sintering the KNN fired powder produced from steps A to C through so-called hot press sintering, in which a predetermined pressure is applied to the KNN fired powder to form a powder compact while simultaneously heating the powder compact. One preferred manner of carrying out hot press sintering will be described with reference to FIG. 2.

FIG. 2 is a schematic view of a sintering apparatus used in hot press sintering. The sintering apparatus 200 shown in FIG. 2 is provided with a processing vessel 203 that is composed of SUS or the like and is internally provided with a processing chamber 201. The inside of the processing chamber 201 is provided with a pressing means 217 (e.g., a hydraulic press pressing means 217) which is configured so as to be able to apply a predetermined pressure to the KNN fired powder 210 when filled in a fixture (sintering die) 208. Furthermore, the inside of the processing chamber 201 is provided with a heater 207 that heats the KNN fired powder 210 inside the fixture 208 to a predetermined temperature. The heater 207 is disposed concentrically surrounding the fixture 208. The inside of the processing chamber 201 is provided with a temperature sensor 209 that measures the temperature inside the processing chamber 201. Each component of the sintering apparatus 200 is connected to a controller 280 configured as a computer, and procedures and conditions described later are controlled by a program run by the controller 280.

First, the KNN fired powder 210 prepared in step C is filled into the fixture 208. At this time, the KNN fired powder 210 is filled into the fixture 208 in a manner that avoids uneven distribution of the KNN fired powder 210 as much as possible. The fixture 208 is preferably constituted from a material such as graphite. Furthermore, the fixture 208 is configured so as to be insertable into the processing chamber 201 of the sintering apparatus 200 and so as to not break when pressure is being applied by the pressing means 217.

Next, the fixture 208 in which the KNN fired powder 210 is filled is placed inside the processing chamber 201 and disposed at a predetermined position of the pressing means 217. Then, a nitrogen gas atmosphere, inert gas atmosphere (e.g., an atmosphere including argon, helium, or other inert gas), or vacuum is created in the processing chamber 201. Once a predetermined atmosphere is created in the processing chamber 201, the pressing means 217 starts actuating and applying pressure to the KNN fired powder 210 filled in the fixture 208, and the heater 207 simultaneously starts heating the KNN fired powder 210. The pressing means 217 is configured to apply pressure in a perpendicular direction to the pressing surface, as shown by the white arrow in FIG. 2. When the pressing means 217 starts actuating, the mechanical pressure applied to the KNN fired powder 210 gradually increases to a predetermined sintering pressure described later, and when the KNN fired powder 210 starts being heated by the heater 207, the temperature of the powder compact produced by pressure application to the KNN fired powder 210 gradually increases from a starting temperature of around room temperature (25 °C) to a predetermined sintering temperature described later.

When the pressure applied to the KNN fired powder 210 reaches the predetermined sintering pressure and the temperature of the KNN fired powder 210 (powder compact) reaches the predetermined sintering temperature, the state of being at the predetermined sintering pressure and predetermined sintering temperature is held for a predetermined duration. This allows the sintering reaction of the KNN fired powder 210 in the powder compact to progress and produce the KNN sintered ceramics.

Examples of the conditions for hot press sintering are given below.

[Hot press sintering conditions]

Atmosphere: nitrogen gas atmosphere, inert gas atmosphere, or vacuum
Sintering pressure (load): 100 kgf/cm$^2$ or more and 500 kgf/cm$^2$ or less, preferably 300 kgf/cm$^2$ or more and 400 kgf/cm$^2$ or less
Sintering temperature: 800 °C or higher and 1150 °C or lower, preferably 850 °C or higher and 1000 °C or lower, more preferably 900 °C or higher and 970 °C or lower
Sintering duration: 1 hour or more and 5 hours or less, preferably 2 hours or more and 3 hours or less

By hot press sintering the KNN fired powder 210 produced through steps A to C under the above conditions, the KNN sintered ceramics, and by extension, the target material 10, can be produced having all three of the characteristics of having a density of 4.2 g/cm$^3$ or less, having a Vickers hardness of 30 or more and 200 or less, and having an area-weighted mean grain size Nv of 3.0 $\mu$m or more. In particular, setting the sintering pressure and sintering temperature within the above ranges facilitates production of the target material 10 having these three characteristics.

Note that it is empirically known that the particle size of the KNN fired powder 210 after hot press sintering will change from the particle size of the KNN fired powder 210 before hot press sintering, and the particle size of the KNbO$_3$ powder, in particular, is likely to change. Furthermore, the value of the area-weighted mean grain size Nv of the target material 10 after hot press sintering as determined from EBSD is likely to be smaller than the mean primary particle size of the KNN fired powder 210 before hot press sintering as determined from the SEM image. Therefore, while it is difficult to compare the change in the particle size of the KNN fired powder 210 before and after sintering under different measurement methods, in order for the area-weighted mean grain size Nv of the target material 10 after hot press sintering as determined from EBSD to be 3.0 $\mu$m or more, it is important that the mean primary particle size of the KNN fired powder 210 produced through steps A to C, in particular, the mean primary particle size of the NaNbO$_3$ powder, is large. Mean primary particle size of 5.0 $\mu$m or more for the NaNbO$_3$ powder and mean primary particle size of 3.0 $\mu$m or more for the KNbO$_3$ powder, respectively, as determined from SEM images can ensure the target material 10 with the characteristic of having the area-weighted mean grain size Nv of 3.0 $\mu$m or more as determined from EBSD.

When the sintering pressure is less than 100 kgf/cm$^2$ or the sintering temperature is less than 800 °C, the Vickers hardness of the target material 10 may be less than 30. Furthermore, when the sintering pressure exceeds 500 kgf/cm$^2$, the powder compact may be excessively densified, leading to the target material 10 having a density exceeding 4.2 g/cm$^3$. Furthermore, when the sintering temperature exceeds 1150 °C, some of the K of the KNN sintering powder is liable to vaporize, and the target material 10 may not be produced with the desired composition.

Furthermore, the sintering pressure of 300 kgf/cm$^2$ or more and 400 kgf/cm$^2$ or less and/or the sintering temperature of 850 °C or higher, preferably 900 °C or higher, can ensure the target material 10 having the three characteristics. Furthermore, the sintering temperature of 1000 °C or lower, preferably 970 °C or lower, can reduce the likelihood some of the K in the KNN sintering powder vaporizing and ensure the target material 10 with the desired composition.

<Step E: Oxidation treatment>

Since step D (hot press sintering) described above is carried out in a nitrogen gas atmosphere, inert gas atmosphere, or vacuum, some of the oxygen (O) in the KNN sintering powder will be desorbed when step D is carried out. Consequently, the composition of the final resulting target material 10, specifically, the O composition, may deviate from the desired composition. Therefore, after step D, a heat treatment (oxidation treatment) is applied to the target material 10 (oxide sintered ceramics) in an O-containing atmosphere. This allows the target material 10, having lost some O from desorption in step D, to absorb O and allows the final resulting target material 10 to achieve the desired composition.

This step is carried out in an O-containing atmosphere at a heating temperature of, for example, 500 °C or higher and 1100 °C or lower, preferably 600 °C or higher and 950 °C or lower, more preferably 650 °C or higher and 900 °C or lower. The heating duration in this step can be, for example, one hour or more, preferably 5 hours or more, more preferably 10 hours or more.

By applying the oxidation treatment under the above conditions to the target material 10 prepared in step D described above, enough O can be absorbed into the center of the target material 10 for oxidation to sufficiently reach the center of the target material 10. Thus, the composition of the final resulting target material 10 can achieve the desired composition.

Note that the target material 10 prepared in step D is a low density target material 10, specifically, the target material 10 with a density of 4.2 g/cm$^3$ or less. Therefore, even when the heating temperature in the oxidation treatment is 1100 °C or lower, preferably 950 °C or lower, particularly, 900 °C or lower, that is, even when the heating temperature in the oxidation treatment is low, enough O can be absorbed into the center of the target material 10 for oxidation to sufficiently reach the center of the target material 10. This allows the target material 10 to have the desired O composition throughout its entire structure (throughout the entire structure of the target material 10 in the thickness direction and in-plane direction).

Furthermore, using a low temperature for the heating temperature of the oxidation treatment can reduce the likelihood of some of the K in the target material 10 vaporizing during the oxidation treatment. This allows the target material 10 to have the desired K composition throughout the entire structure.

Furthermore, by using a low heating temperature in the oxidation treatment, the target material 10 will be less susceptible to warping and fractures during the oxidation treatment. Consequently, this can improve the production yield of the target material 10.

Furthermore, since the target material 10 has a low density, a heating duration of one hour or more under the above heating temperatures can allow enough O to be absorbed into the center of the target material 10 for oxidization to sufficiently reach the center of the target material 10. Furthermore, a heating duration of five hours or more under the above heating temperatures can ensure that oxidation reaches the center of the target material 10, and a heating duration of 10 hours or more under the above heating temperature can better ensure that oxidation reaches the center of the target material 10.

When the heating temperature in the oxidation treatment is less than 500 °C or the heating duration at the above heating temperatures is less than one hour, then it will be difficult for oxidation to sufficiently reach the center of the target material 10 even when the target material 10 has a low density. Consequently, the target material 10 may not have the desired O composition throughout its entire structure. Furthermore, when the heating temperature in the oxidation treatment exceeds 1100 °C, the target material 10 may not have the desired K composition throughout its entire structure due to some of the K in the target material 10 vaporizing. Furthermore, the target material 10 will be more susceptible to warping and fractures during oxidation treatment.

Note that the upper limit of the heating duration under the above temperatures is not particularly limited. However, when the heating duration is too long, not only will the effect of absorbing O into the target material 10 saturate, but some of the K in the target material 10 will likely vaporize. Furthermore, this may also invite lower production efficiency in producing the target material 10 and increases in production cost. Therefore, the heating duration under the heating temperatures described above is preferably 40 hours or less, more preferably 20 hours or less, even more preferably 15 hours or less.

In this step, multiple stages of oxidation treatment may be carried out at different heating temperatures from the viewpoint of ensuring oxidation reaches the center of the target material 10.

<Finishing and bonding to the backing plate>

Next, the target material 10 according to the present aspect is produced by grinding the sintered ceramics, as necessary, into a disk shape having dimensions with an area of 4500 mm$^2$ or more and a thickness of 3 mm or more, for example, and/or adjusting the surface state by polishing the surface. The target material 10 is joined to a backing plate composed of Cu or the like via a bonding material containing In, Sn, or an alloy thereof, for use as a sputtering target.

(3) Effect

According to the present aspect, one or more of the advantageous effects described below can be obtained.

(a) The target material 10 according to the present aspect is provided with the three characteristics of having a density of 4.2 g/cm$^3$ or less, having a Vickers hardness of 30 or more and 200 or less, and having an area-weighted mean grain size Nv of 3.0 $\mu$m or more. This allows for the target material 10 with low density and high resistance to fracture. Furthermore, a low density (density of 4.2 g/cm$^3$ or less) for the target material 10 allows the target material 10 to be produced with the desired O and K composition throughout the entire structure of the target material 10 (throughout the entire structure of the target material 10 in the thickness direction and in-plane direction). Therefore, according to the present aspect, the target material 10 with the desired O and K composition throughout the entire structure and high resistance to fracture can be produced. This can ensure that a highly reliable KNN film with predetermined physical properties and predetermined characteristics can be produced by sputter deposition using the target material 10.

(b) The target material 10 according to the present aspect is prepared from the KNN fired powder prepared through the new technique detailed in steps A to C described above. Through this technique, the KNN fired powder with a large mean primary particle size, for example, a mean primary particle size of 3.0 $\mu$m or more, can be produced. By hot press sintering the KNN fired powder having such a large mean primary particle size under predetermined conditions, the target material 10 with the three characteristics described above can be produced.

(c) By preparing the NaNbO$_3$ powder and KNbO$_3$ powder separately, primary firing temperature A for preparing the NaNbO$_3$ powder can be increased. For example, primary firing temperature A can be made higher than primary firing temperature of conventional techniques in which a fired powder containing K, Na, and Nb is prepared by carrying out a primary firing process on a powder mixture of K$_2$CO$_3$ powder, Na$_2$CO$_3$ powder, and Nb$_2$O$_5$ powder in an O-containing atmosphere using an electric furnace or other such furnace. Since primary firing temperature A can be increased in this manner, the mean primary particle size of the resulting NaNbO$_3$ can be made sufficiently large. Preparing the NaNbO$_3$ powder with a large mean primary particle size in step A can ensure the target material 10 with the characteristic of having the area-weighted mean grain size Nv of 3.0 $\mu$m or more and consequently can ensure the target material 10 having the above three characteristics.

(d) The mixing ratio of the K$_2$CO$_3$ powder and Nb$_2$O$_5$ powder is adjusted in step B so that the KNbO$_3$ powder with a large mean primary particle size is prepared. Preparing the KNbO$_3$ powder with a large mean primary particle size can ensure the target material 10 with the characteristic of having the area-weighted mean grain size Nv of 3.0 $\mu$m or more and consequently can better ensure the target material 10 with the above three characteristics. Furthermore, adjusting the mixing ratio of the K$_2$CO$_3$ powder and Nb$_2$O$_5$ powder in step B such that the composition of the KNbO$_3$

powder becomes K-rich can better ensure the $KNbO_3$ powder with a large mean primary particle size, for example, a mean primary particle size of 3.0 $\mu$m or more, and consequently can better ensure the target material 10 with the above three characteristics.

(e) Since the $NaNbO_3$ powder and $KNbO_3$ powder with large mean primary particle sizes are respectively prepared in steps A and B, the final resulting target material 10 can be provided with the characteristic of a plurality of crystal grains observed on the sputtering surface 10s primarily including a plurality of $NaNbO_3$ grains and a plurality of $KNbO_3$ grains. Furthermore, the target material 10 can also be provided with the characteristic of Na-rich portions and K-rich portions being present (scattered) on the sputtering surface 10s.

Note that it is also conceivable to use the KNN fired powder prepared in the manner described below for the hot press sintering process. That is, first, a $K_2CO_3$ powder, $Na_2CO_3$ powder, and $Nb_2O_5$ powder are prepared as starting material powders. Then, each of these starting material powders are weighed and the mixing ratio of the starting material powders is adjusted such that the final resulting target material 10 will have the desired composition. The primary firing process is carried out on the resulting powder mixture of $K_2CO_3$ powder, $Na_2CO_3$ powder, and $Nb_2O_5$ powder using an electric furnace or other such furnace in an O-containing atmosphere, producing fired material containing K, Na, and Nb (($K, Na)NbO_3$). Next, a predetermined milling means is used to coarsely mill the resulting fired material and produce a fired powder (($K, Na)NbO_3$ powder). The fired powder is then coarsely milled using a predetermined milling means to produce KNN fired powder. However, even when hot press sintering is carried out using the KNN fired powder produced by this technique, a target material with all three of the characteristics of having a density of 4.2 g/cm$^3$ or less, having a Vickers hardness of 30 or more and 200 or less, and having an area-weighted mean grain size Nv of 3.0 $\mu$m or more cannot be produced.

The reason for this is that in the above method for producing a KNN fired powder, a KNN fired powder with a mean primary particle size of 3.0 $\mu$m or more cannot be produced when the heating temperature in primary firing is low. When hot press sintering is carried out using the resulting KNN fired powder under a similar temperature (sintering temperature) as that in step D described above, the density of the resulting KNN sintered ceramics (target material) becomes high. That is, a target material with the characteristic of having a density of 4.2 g/cm$^3$ or less cannot be produced. Furthermore, when hot press sintering is carried out using this KNN fired powder at a temperature lower than the sintering temperature in step D described above, the target material cannot be constituted by crystal grains with a large mean grain size. That is, a target material with the characteristic of having the area-weighted mean grain size Nv of 3.0 $\mu$m or more cannot be produced.

On the other hand, when the heating temperature in primary firing is high under the above method for producing a KNN fired powder, a KNN fired powder with a mean primary particle size of 3.0 $\mu$m or more can be produced. However, the KNN fired powder resulting from this technique contains an even mix of fired powder containing Na and Nb ($NaNbO_3$ powder) and fired powder containing K and Nb ($KNbO_3$ powder). Therefore, when hot press sintering is carried out using this KNN fired powder at a similar temperature to that of the sintering temperature in step D described above, the density of the resulting target material becomes too high. That is, a target material with the characteristic of having a density of 4.2 g/cm$^3$ or less cannot be produced. Furthermore, when hot press sintering is carried out using this KNN fired powder at a lower temperature than the sintering temperature in step D described above, a target material with the characteristic of having a Vickers hardness of 30 or more and 200 or less cannot be produced.

In contrast, in the present aspect, the $NaNbO_3$ powder and $KNbO_3$ powder are prepared separately, as described above, and the prepared $NaNbO_3$ powder and $KNbO_3$ powder are mixed and calcined to prepare the KNN fired powder. This, as described above, allows the KNN fired powder with a mean primary particle size of 3.0 $\mu$m or more to be produced. Furthermore, in the technique used in the present aspect, a deliberate effort is made to keep the $NaNbO_3$ powder and $KNbO_3$ powder from evenly mixing (to make these powders mix unevenly). By carrying out hot press sintering using this KNN fired powder at the sintering temperature in step D described above, the target material 10 can be provided with all three of the characteristics of having a density of 4.2 g/cm$^3$ or less, having a Vickers hardness of 30 or more and 200 or less, and having an area-weighted mean grain size Nv of 3.0 $\mu$m or more. Furthermore, by keeping the $NaNbO_3$ powder and $KNbO_3$ powder from mixing evenly in step C, the target material 10 can be provided with the characteristic of Na-rich portions and K-rich portions being scattered on the sputtering surface 10s.

Furthermore, in the above aspect, the KNN fired powder is sintered through hot press sintering, but it is also conceivable to sinter the KNN fired powder through spark plasma sintering (hereinafter also simply referred to as SPS). However, the powder compact is liable to densify excessively when sintered by SPS. Therefore, the target material 10 may not be produced with a density of 4.2 g/cm$^3$.

<Another aspect of the present disclosure>

Various aspects of the present disclosure have been specifically described heretofore. However, the present disclosure is not limited to the aspects described above, and various modifications are conceivable without departing from the spirit of the present disclosure.

In addition to at least one element selected from the group consisting of Cu and Mn, or in place of the at least one element selected from the group consisting of Cu and Mn, at least one element (dopant) selected from the group described below may be added to the target material 10 at a concentration of, for example, 5 at% or less. Examples of the dopant include at least one element selected from the group consisting of lithium (Li), magnesium (Mg), calcium (Ca), strontium (Sr), barium (Ba), bismuth (Bi), antimony (Sb), vanadium (V), indium (In), tantalum (Ta), molybdenum (Mo), tungsten (W), chromium (Cr), titanium (Ti), zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), zinc (Zn), silver (Ag), iron (Fe), cobalt (Co), nickel (Ni), aluminum (Al), silicon (Si), germanium (Ge), tin (Sn), and gallium (Ga). When a plurality of the above elements are added, the total concentration will be 5 at% or less, and the added amount of dopant is usually 0.1 at% or more. In this case, a powder containing at least one dopant element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Zn, Ag, Fe, Co, Ni, Al, Si, Ge, Sn, and Ga, e.g., a powder of that element in its pure form, an oxide powder containing that element, a composite oxide powder containing that element, or a powder of a compound containing that element that becomes an oxide when heated (e.g., carbonate, oxalate), may be further prepared in step C described above and mixed with the $NaNbO_3$ powder and $KNbO_3$ powder.

EXAMPLES

Test results supporting the effects of the aspect described above will be described below, but the present disclosure is not limited to the following examples.

(Sample 1)

The $Na_2CO_3$ powder and $Nb_2O_5$ powder were mixed at a predetermined ratio, and the powder mixture of $Na_2CO_3$ powder and $Nb_2O_5$ powder was heated in an O-containing atmosphere at 1200 °C to prepare the $NaNbO_3$ powder (step A). Furthermore, the $K_2CO_3$ powder and $Nb_2O_5$ powder were mixed at a predetermined ratio, and the powder mixture of $K_2CO_3$ powder and $Nb_2O_5$ powder was heated in an O-containing atmosphere at 800 °C to prepare the $KNbO_3$ powder (step B). In step B, the mixing ratio of the $K_2CO_3$ powder and $Nb_2O_5$ powder were adjusted so that the $KNbO_3$ powder has a K-rich composition. The K/Nb ratio of the $KNbO_3$ powder prepared in step B (the ratio of the K composition of the $KNbO_3$ powder to the Nb composition) was 1.015. Next, the $NaNbO_3$ powder and $KNbO_3$ powder that were prepared were mixed with a CuO powder at a predetermined ratio, and the powder mixture of the $NaNbO_3$ powder, $KNbO_3$ powder, and CuO powder was heated in an O-containing atmosphere at 750 °C to prepare a KNN fired powder containing Cu as a dopant (step C). The resulting KNN fired powder was hot pressed sintered at a sintering pressure of 400 kgf/cm$^2$ and a sintering temperature of 900 °C to prepare a KNN sintered ceramics (step D). A heat treatment (oxidation treatment) was applied to the resulting KNN sintered ceramics in an O-containing atmosphere at 800 °C for one hour (step E). Then, the surface of the KNN sintered ceramics was subjected to a predetermined machining process such as grinding to produce a disk-like KNN target material with a thickness of 5 mm and a diameter of 300 mm (300 mmφ). This KNN target material was considered to be sample 1.

The target materials for samples 2 to 29 were prepared with the changes indicated in Table 1 being made to the temperature (primary firing temperature A) in step A, the K/Nb ratio (i.e., the mixing ratio of $K_2CO_3$ powder and $Nb_2O_5$ powder) in step B, the temperature (primary firing temperature B) in step B, the pressure (sintering pressure) in step D, the temperature (sintering temperature) in step D, the condition of whether or not step E was performed, or the temperature in step E, with the other procedures and conditions in preparation being similar to those used for sample 1. Note that "○" in the step E column of Table 1 means that step E was performed and "×" means that step E was not performed.

Furthermore, the target materials for samples 30 to 33 were prepared in various sizes by changing the fixture (sintering die) used in step D, and the other procedures and conditions in preparation were similar to those used for sample 1. Note that the target materials for samples 30 to 32 have disk-like shapes, while the target material for sample 33 has a plate shape with rectangular main surfaces. The sizes of the target materials for samples 30 to 33 were as shown in Table 1.

[Table 1]

| Sample | Step A Temperature (°C) | Step A Mean size (μm) | K/Nb ratio | Step B Temperature (°C) | Step B Mean size (μm) | Step C Temperature (°C) | Step C Amount of added dopant (at%) | Step D Pressure (kgf/cm²) | Step D Temperature (°C) | Step E Performed? | Step E Temperature (°C) | Size (mm) |
|---|---|---|---|---|---|---|---|---|---|---|---|---|
| 1 | 1200 | 10.0 | 1.015 | 800 | 7.0 | 750 | 0.5 | 400 | 900 | ○ | 800 | 300φ |
| 2 | 1000 | 8.0 | 1.015 | 800 | 6.0 | 750 | 0.5 | 400 | 900 | ○ | 800 | 300φ |
| 3 | 1100 | 11.0 | 1.015 | 800 | 7.5 | 750 | 0.5 | 400 | 900 | ○ | 800 | 300φ |
| 4 | 1300 | 12.0 | 1.015 | 800 | 7.0 | 750 | 0.5 | 400 | 900 | ○ | 800 | 300φ |
| 5 | 800 | 3.0 | 1.015 | 800 | 6.0 | 750 | 0.5 | 400 | 900 | ○ | 800 | 300φ |
| 6 | 900 | 4.0 | 1.005 | 800 | 7.0 | 750 | 0.5 | 400 | 900 | ○ | 800 | 300φ |
| 7 | 1200 | 10.0 | 1.010 | 800 | 7.5 | 750 | 0.5 | 400 | 900 | ○ | 800 | 300φ |
| 8 | 1200 | 12.0 | 1.050 | 800 | 8.0 | 750 | 0.5 | 400 | 900 | ○ | 800 | 300φ |
| 9 | 1200 | 10.0 | 1.080 | 800 | 8.0 | 750 | 0.5 | 400 | 900 | ○ | 800 | 300φ |
| 10 | 1200 | 11.0 | 1.100 | 800 | 8.0 | 750 | 0.5 | 400 | 900 | ○ | 800 | 300φ |
| 11 | 1200 | 10.0 | 1.001 | 800 | 2.5 | 750 | 0.5 | 400 | 900 | ○ | 800 | 300φ |
| 12 | 1200 | 10.0 | 1.015 | 800 | 5.0 | 750 | 0.5 | 400 | 900 | ○ | 800 | 300φ |
| 13 | 1200 | 10.0 | 1.015 | 500 | 5.0 | 750 | 0.5 | 400 | 900 | ○ | 800 | 300φ |
| 14 | 1200 | 11.0 | 1.015 | 600 | 5.5 | 750 | 0.5 | 400 | 900 | ○ | 800 | 300φ |
| 15 | 1200 | 10.0 | 1.015 | 650 | 6.0 | 750 | 0.5 | 400 | 900 | ○ | 800 | 300φ |
| 16 | 1200 | 10.0 | 1.015 | 700 | 7.5 | 750 | 0.5 | 400 | 900 | ○ | 800 | 300φ |
| 17 | 1200 | 10.0 | 1.015 | 900 | 2.0 | 750 | 0.5 | 400 | 900 | ○ | 800 | 300φ |
| 18 | 1200 | 12.0 | 1.015 | 450 | 7.0 | 750 | 0.5 | 400 | 900 | ○ | 800 | 300φ |
| 19 | 1200 | 10.0 | 1.015 | 800 | 7.0 | 750 | 0.5 | 50 | 900 | ○ | 800 | 300φ |
| 20 | 1200 | 10.0 | 1.015 | 800 | 6.0 | 750 | 0.5 | 100 | 900 | ○ | 800 | 300φ |
| 21 | 1200 | 11.0 | 1.015 | 800 | 7.0 | 750 | 0.5 | 600 | 900 | ○ | 800 | 300φ |
| 22 | 1200 | 10.0 | 1.015 | 800 | 7.0 | 750 | 0.5 | 400 | 750 | ○ | 800 | 300φ |
| 23 | 1200 | 10.0 | 1.015 | 800 | 8.0 | 750 | 0.5 | 400 | 800 | ○ | 800 | 300φ |
| 24 | 1200 | 10.0 | 1.015 | 800 | 7.0 | 750 | 0.5 | 400 | 1200 | ○ | 800 | 300φ |
| 25 | 1200 | 10.0 | 1.015 | 800 | 7.0 | 750 | 0.5 | 400 | 900 | × | — | 300φ |
| 26 | 1200 | 11.0 | 1.015 | 800 | 8.0 | 750 | 0.5 | 400 | 900 | ○ | 500 | 300φ |
| 27 | 1200 | 10.0 | 1.015 | 800 | 7.0 | 750 | 0.5 | 400 | 900 | ○ | 700 | 300φ |
| 28 | 1200 | 12.0 | 1.015 | 800 | 7.0 | 750 | 0.5 | 400 | 900 | ○ | 900 | 300φ |
| 29 | 1200 | 10.0 | 1.015 | 800 | 7.0 | 750 | 0.5 | 400 | 900 | ○ | 1100 | 300φ |
| 30 | 1200 | 10.0 | 1.015 | 800 | 6.0 | 750 | 0.5 | 400 | 900 | ○ | 800 | 75φ |
| 31 | 1200 | 11.0 | 1.015 | 800 | 6.0 | 750 | 0.5 | 400 | 900 | ○ | 800 | 100φ |
| 32 | 1200 | 10.0 | 1.015 | 800 | 7.0 | 750 | 0.5 | 400 | 900 | ○ | 800 | 150φ |
| 33 | 1200 | 10.0 | 1.015 | 800 | 7.0 | 750 | 0.5 | 400 | 900 | ○ | 800 | 90x250 |

<Evaluation of NaNbO$_3$ powder prepared in step A>

The measurement results for the mean primary particle size of the NaNbO$_3$ powder prepared for samples 1 to 33 are shown in Table 1. Note that "mean size" in Table 1 means the mean primary particle size of the NaNbO$_3$ powder determined from an SEM image, specifically, the median diameter D$_{50}$ of primary particles in the NaNbO$_3$ powder.

In all of samples 1 to 4 and 7 to 33, it was observed that the mean primary particle size of the NaNbO$_3$ powder was 5.0 μm or more. Accordingly, it is understood that a temperature of 1000 °C or higher in step A allows for the NaNbO$_3$ powder with a mean primary particle size of 5.0 μm or more (8.0 μm or more in the examples). Furthermore, in all of samples 1 to 4 and 7 to 33, it is understood that the mean primary particle size of NaNbO$_3$ powder is larger than the mean primary particle size of the KNbO$_3$ powder prepared in step B.

Furthermore, in all of samples 1, 3, 4, and 7 to 33, it was observed that the mean primary particle size of NaNbO$_3$ powder was 10.0 μm or more. Accordingly, it is understood that a temperature of 1100 °C or higher in step A allows the NaNbO$_3$ powder with a mean primary particle size of 10.0 μm or more to be produced, that is, ensures the NaNbO$_3$ powder with a large mean primary particle size.

Note that in both of samples 5 and 6, it was observed that the mean primary particle size of NaNbO$_3$ powder was less than 5.0 μm. Accordingly, it is understood that when the temperature in step A is less than 1000 °C, the primary particles in NaNbO$_3$ powder may not become large enough.

Furthermore, from sample 6, it is understood that even when the temperature in step A is higher than the temperature in step B, the mean primary particle size of the NaNbO$_3$ powder may not be larger than the mean primary particle size of the KNbO$_3$ powder prepared in step B should the temperature in step A be less than 1000 °C.

<Evaluation of KNbO$_3$ powder prepared in step B >

The measurement results for the mean primary particle size of the KNbO$_3$ powder prepared for samples 1 to 33 are shown in Table 1. Note that "K/Nb ratio" in Table 1 is the ratio of the K composition in the prepared KNbO$_3$ powder to the Nb composition. Furthermore, "mean size" in Table 1 means the mean primary particle size of the KNbO$_3$ powder determined from an SEM image, specifically, the median diameter D$_{50}$ of primary particles in the KNbO$_3$ powder.

In all of samples 1 to 11, 13 to 17, and 19 to 33, it was observed that the mean primary particle size of the KNbO$_3$ powder was 3.0 μm or more (5.0 μm or more in the examples). Accordingly, it is understood that a K/Nb ratio of 1.005 or more allows for the KNbO$_3$ powder with a mean primary particle size of 3.0 μm or more. It is also understood that a temperature of 500 °C or higher in step B can ensure the KNbO$_3$ powder with a mean primary particle size of 3.0 μm or more.

Note that in sample 12, it was observed that the mean primary particle size of KNbO$_3$ powder was less than 3.0 μm. Accordingly, it is understood that the primary particles of the KNbO$_3$ powder may not become large enough when the K/Nb ratio is less than 1.005.

Furthermore, in sample 18, it was observed that the mean primary particle size of the KNbO$_3$ powder was less than 3.0 μm. Accordingly, it is understood that even when the K/Nb ratio is 1.005 or higher, the mean primary particle size of the KNbO$_3$ powder may not become large enough when the temperature in step B is less than 500 °C.

<Evaluation of target material>

The physical properties of each sample (target material) were also evaluated with respect to density, Vickers hardness, mean grain size, and K, Na, and Nb composition. Furthermore, each sample was also evaluated for fractures.

(Evaluation of density)

The density of the target materials of samples 1 to 33 was measured using the device and method described below.

Device: Electronic densimeter MDS300 manufactured by Alfa Mirage Co., Ltd.
Test method: Each piece of target material cut into a predetermined size is measured in density, using the above device, based on Archimedes' Principle.

(Evaluation of Vickers hardness)

The Vickers hardness of the target materials of samples 1 to 33 was measured using the device, conditions, and method described below.

Device: Micro Vickers hardness testing machine HM-114 manufactured by Mitutoyo Corporation
Atmosphere: air
Temperature: room temperature (25 °C)
Test force: 1.0 kgf
Load applying speed: 10 $\mu$m/s
Dwell time: 15 sec
Number of measurement points: 5 points

Test method: This test conforms to JIS R 1610 and involves using a Vickers indenter (a square base pyramid indenter with an angle of 136 degrees between opposing sides) to determine the Vickers hardness from the test force at the time an indent is made on the test surface and the surface area of the indent as determined from the length of the diagonal of the indent and averaging the measurement results at five points.

(Evaluation of mean grain size)

The sputtering surface of the target materials of samples 1 to 33 was observed through EBSD, and the area-weighted mean grain size Nv ($\mu$m) for the plurality of crystal grains observed on the sputtering surface was measured using the device, conditions, and method described below.

Sample preparation: Prepared by polishing (polishing with waterproof abrasive paper until there are no large defects that are obstructive to evaluation and then buff polishing)
Device: Ultra-high resolution analytical scanning electron microscope SU-70 manufactured by Hitachi High-Tech Corporation
EBSD detector manufactured by TSL SOLUTIONS, K.K.
Analysis software: OIM Analysis Ver8 developed by TSL SOLUTIONS, K.K.
Measurement magnification: 3000 times
Measured area: 30 $\mu$m $\times$ 50 $\mu$m
Step size: 0.06 $\mu$m
Grain boundary angle: 15°

Analysis method: Grain size was analyzed from a grain boundary map created after a clean up was performed to reduce noise, under the condition of a grain boundary angle of 15° (boundaries with a grain misorientation of 15° or more are treated as grain boundaries). When voids or the like were present, a threshold was set for the IQ (Image Quality) value. The area and grain size (equivalent circular diameter) of each grain were calculated using the area fraction method for EBSD, and the area-weighted mean grain size was calculated. Furthermore, since portions with poor crystallinity which cannot be analyzed and microcrystals were removed as noise from the grain size calculation, grains of 0.20 $\mu$m or greater were used in the calculations.

(Evaluation of K, Na, and Nb composition)

The composition of the target materials for samples 1 to 33 was measured by measuring the molar quantities of K and Na through AAS, measuring the molar quantity of Nb through ICP-AES, and calculating the value of ([K]+[Na])/[Nb]. Note that [K], [Na], and [Nb] represent the molar quantities of the K atoms, Na atoms, and Nb atoms in the target material. [K], [Na], and [Nb] were measured using the device, conditions, and method described below.

Sample preparation: Each sample was cut to a size of 10 mm $\times$ 10 mm ($\times$ thickness 5mm).
Device: Atomic Absorption Spectrophotometer (AAS) Z-2300 manufactured by Hitachi High-Technologies Corporation
Inductively Coupled Plasma Atomic Emission Spectrophotometer (ICP-AES) PS3520VDDII manufactured by Hitachi High-Tech Science
Analysis method: Each cut sample was heated and decomposed in sulfuric acid, nitric acid, hydrofluoric acid, and hydrochloric acid, then heated and dissolved in dilute hydrogen peroxide and dilute hydrofluoric acid and made to volume. Then, AAS and ICP-AES were performed on the solution to determine the content of K, Na, and Nb in the sample which was then converted to an atomic ratio.

(Evaluation of fractures)

Samples 1 to 33 after step E (oxidation treatment) were visually inspected for any fractures (including cracking and chipping).

Furthermore, KNN films were sputter deposited using the procedures described below and each of samples 1 to 4, 6 to 17, 20, 21, 23, and 25 to 33, which had shown no abnormal composition or fractures after step E (oxidation treatment). Then, each sputter-deposited sample was visually inspected for fractures (including cracks and chipping) and traces of abnormal discharge.

As substrates, Si substrates were prepared, each having a 4 inch diameter, a 510 $\mu$m thickness, a surface in the (100) direction, and a 200 nm thick thermal oxide film (SiO$_2$ film) formed on the surface. Then, a Ti film as an adhesion layer (2 nm thick), a Pt film as a bottom electrode film (preferential orientation in the (111) direction relative to the surface of the substrate, 200 nm thick), and a KNN film as a piezoelectric film (4 inch diameter, preferential orientation in the (001) direction relative to the surface of the substrate, 2 $\mu$m thick) were sputter deposited on top of the thermal oxide film of the substrate in this order through RF magnetron sputtering (using an RF plasma sputtering apparatus).

The conditions for sputter depositing the adhesion layer and bottom electrode film are as follows.

Substrate temperature: 300 °C
RF power density: 13.5 W/cm$^2$
Atmosphere: Ar gas atmosphere
Ambient pressure: 0.3 Pa
Deposition time: 5 minutes

The conditions for sputter depositing the KNN film are as follows.

RF power density: predetermined RF power density of 2 W/cm$^2$ to 5 W/cm$^2$
Atmosphere: mixed gas atmosphere of Ar gas + O$_2$ gas
Ambient pressure: 0.3 Pa
Ar/O$_2$ partial pressure ratio: 25/1
Temperature (substrate temperature): 600 °C
Deposition rate:1 $\mu$m/hr

The evaluation results (measurement results) are shown in Table 2. Note that "(K+Na)/Nb composition" in Table 2 is the value of ([K]+[Na])/[Nb].

[Table 2]

| Sample | Physical property evaluation | | | | Fracture evaluation | |
|---|---|---|---|---|---|---|
| | Density | Vickers hardness | Nv | (K+Na)/Nb composition | After step E | After sputtering |
| | (g/cm³) | | (μm) | | | |
| 1 | 4.0 | 150 | 5.0 | 1.03 | ○ | ○ |
| 2 | 4.0 | 150 | 3.0 | 1.03 | ○ | ○ |
| 3 | 4.0 | 150 | 5.0 | 1.04 | ○ | ○ |
| 4 | 4.0 | 150 | 6.0 | 1.03 | ○ | ○ |
| 5 | 4.0 | 150 | 2.0 | 1.03 | × | — |
| 6 | 4.0 | 150 | 2.0 | 1.03 | ○ | × |
| 7 | 4.0 | 150 | 3.0 | 1.02 | ○ | ○ |
| 8 | 4.0 | 150 | 4.0 | 1.03 | ○ | ○ |
| 9 | 4.0 | 150 | 6.0 | 1.04 | ○ | ○ |
| 10 | 4.0 | 150 | 6.0 | 1.04 | ○ | ○ |
| 11 | 4.0 | 150 | 6.0 | 1.04 | ○ | ○ |
| 12 | 4.0 | 150 | 2.0 | 1.02 | ○ | × |
| 13 | 4.0 | 150 | 5.0 | 1.03 | ○ | ○ |
| 14 | 4.0 | 150 | 5.0 | 1.03 | ○ | ○ |
| 15 | 4.0 | 150 | 5.0 | 1.03 | ○ | ○ |
| 16 | 4.0 | 150 | 5.0 | 1.03 | ○ | ○ |
| 17 | 4.0 | 150 | 5.0 | 1.03 | ○ | ○ |
| 18 | 4.0 | 150 | 2.0 | 1.03 | × | — |
| 19 | 3.3 | 20 | 3.0 | 1.03 | × | — |
| 20 | 3.5 | 30 | 3.0 | 1.03 | ○ | ○ |
| 21 | 4.5 | 300 | 3.0 | 1.03 (not oxidized on the inside) | ○ | × |
| 22 | 3.2 | 20 | 3.0 | 1.03 | × | — |
| 23 | 3.5 | 30 | 3.0 | 1.03 | ○ | ○ |
| 24 | 4.5 | 300 | 3.0 | 1.01 (K-poor surface) | × | — |
| 25 | 4.0 | 150 | 5.0 | 1.03 | ○ | ○ |
| 26 | 4.0 | 150 | 5.0 | 1.03 | ○ | ○ |
| 27 | 4.0 | 150 | 5.0 | 1.03 | ○ | ○ |
| 28 | 4.0 | 150 | 5.0 | 1.03 | ○ | ○ |
| 29 | 4.0 | 200 | 6.0 | 1.02 | ○ | ○ |
| 30 | 4.0 | 150 | 5.0 | 1.03 | ○ | ○ |
| 31 | 4.0 | 150 | 5.0 | 1.03 | ○ | ○ |
| 32 | 4.0 | 150 | 5.0 | 1.03 | ○ | ○ |
| 33 | 4.0 | 150 | 5.0 | 1.03 | ○ | ○ |

In all of samples 1 to 4, 7 to 11, 13 to 17, 20, 23, and 25 to 33, it was observed that the density was 4.2 g/cm³ or less, the Vickers hardness was 30 or more and 200 or less, and the area-weighted mean grain size Nv was 3.0 μm or more. Furthermore, no fractures were observed in these samples after step E and after sputtering deposition. Furthermore, in these samples, no fractures were observed in the target material when the KNN film was sputter deposited to a cumulative thickness of over 50 μm. Accordingly, it is understood that these samples are target materials which are low in density and highly resistant to fractures.

Furthermore, it is understood from samples 30 to 33 that a target material that is low in density and highly resistant to fractures can be produced regardless of the size and planar shape of the target material.

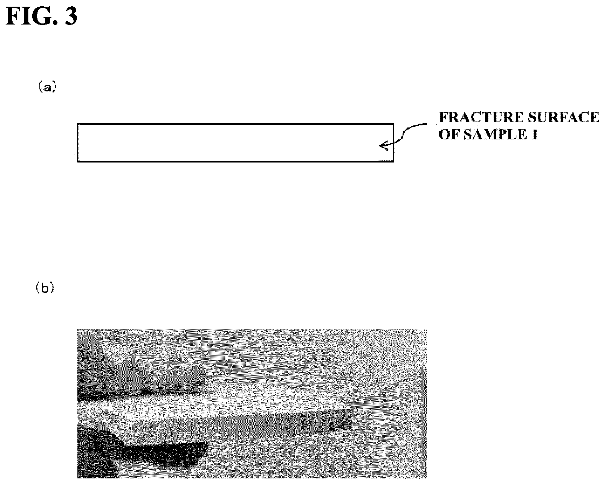

Furthermore, the target materials of samples 1 to 4, 7 to 11, 13 to 17, 20, 23, and 25 to 33 were split in the thickness direction, and the fracture surface (vertical cross section) was visually inspected. As one example, FIG. 3(a) shows a schematic view of the fracture surface of sample 1, and FIG. 3(b) shows a photograph of the fracture surface of sample 1. It was observed from FIG. 3(a) and FIG. 3(b) that the surface (top and bottom) of sample 1 and the interior (center) were white, that is, it can be seen that the entire structure of sample 1 was white. This indicates that oxidation has sufficiently reached the center of sample 1, that is, that the desired O composition was achieved throughout the entire structure of sample 1. Similarly, it was observed that the vertical cross sections of samples 2 to 4, 7 to 11, 13 to 17, 20, 23, and 25 to 33 were also white throughout their entire structures. Accordingly, in all of samples 1 to 4, 7 to 11, 13 to 17, 20, 23, and 25 to 33, it is understood that oxidation sufficiently reached the center of the target material even when the oxidation treatment was carried out a low temperature less than 1000 °C (even when the temperature in step E was less than 1000 °C).

Furthermore, in all of samples 1 to 4, 7 to 11, 13 to 17, 20, 23, and 25 to 33, it was observed that the value of ([K]+[Na])/[Nb] exceeded 1.0.

Furthermore, from sample 25, it is understood that a density of 4.2 g/cm$^3$ or less, a Vickers hardness of 30 or more and 200 or less, and an area-weighted mean grain size Nv of 3.0 $\mu$m or more may allow a target material that is low in density and highly resistant to fractures to be produced even without step E (oxidation treatment). However, from the viewpoint of ensuring a target material with the desired O composition throughout the entire structure, it is preferable to perform step E.

Note that in all of samples 5, 6, 12, and 18, it was observed that the area-weighted mean grain size Nv was less than 3.0 $\mu$m. Accordingly, it is understood that the target material may not achieve the area-weighted mean grain size Nv of 3.0 $\mu$m or more when the mean primary particle size of the NaNbO$_3$ powder cannot be made large enough in step A or when the mean primary particle size of the KNbO$_3$ powder cannot be made large enough in step B. Furthermore, in samples 5 and 18, it was observed that there were fractures after step E, and in samples 6 and 12, it was observed that there were fractures (cracks) and abnormal discharges after sputtering deposition. Accordingly, it is understood that when the target material has the area-weighted mean grain size Nv of less than 3.0 $\mu$m, the target material will be susceptible to fractures while the target material is being prepared or during sputter deposition.

In samples 19 and 22, it was observed that the Vickers hardness was less than 30. Accordingly, it is understood that a Vickers hardness of 30 or more may not be achieved when the pressure in step D is less than 100 kgf/cm$^2$ or the temperature in step D is less than 800 °C. Furthermore, in samples 19 and 22, it was observed that there were fractures after step E. Accordingly, it is understood that when the target material has a Vickers hardness of less than 30, the target material will be susceptible to fractures while the target material is being prepared or during sputter deposition.

In samples 21 and 24, it was observed that the Vickers hardness exceeded 200. Accordingly, it is understood that to produce a target material with a Vickers hardness exceeding 200, it is necessary for the pressure in step D to exceed 500 kgf/cm$^2$ or for the temperature in step D to exceed 1150 °C. Furthermore, in samples 21 and 24, it was observed that the density exceeded 4.2 g/cm$^3$.

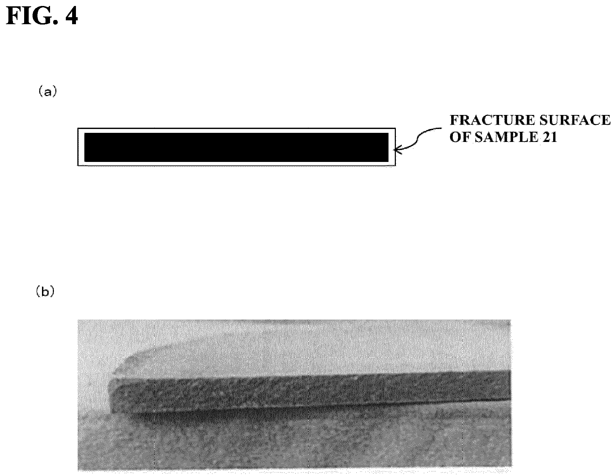

Furthermore, the target material of sample 21 was split in the thickness direction, and the fracture surface (vertical cross section) was visually inspected. FIG. 4(a) shows a schematic view of the fracture surface of sample 21, and FIG. 4(b) shows a photograph of the fracture surface of sample 21. From FIG. 4(a) and FIG. 4(b), it was observed that while the surface (top and bottom) of sample 21 was white, the inside (center) was gray, navy blue, or black. This is because while the surface of sample 21 was oxidized, the center had little O (i.e., was unoxidized). Accordingly, it is understood that when the pressure in step D is high, the density exceeds 4.2 g/cm$^3$, in which case, oxidation may not sufficiently reach the center of the target material when the temperature in step E is less than 1000 °C. That is, it is understood that the desired O composition may not be achieved throughout the entire structure of the target material. Furthermore, in sample 21, it was observed that there were cracks and abnormal discharges after sputter deposition.

Furthermore, in sample 24, it was observed that the surface composition was K-poor. Accordingly, it is understood that when the temperature in step D exceeds 1100 °C, the desired K composition may not be achieved throughout the entire structure of the target material due to some of the K of the target material vaporizing. Furthermore, in sample 24, it was observed that there were fractures after step E. Accordingly, it is also understood that when the temperature in step D is high, the target material may fracture while the target material is being prepared.

<Preferred aspects of the present disclosure>

Hereinafter, aspects of the present disclosure will be supplementarily described.

(Supplementary description 1)

According to an aspect of the present disclosure, there is provided

a sputtering target material constituted from a sintered ceramics of an oxide containing potassium, sodium, niobium, and oxygen, wherein
the sputtering target material has a density of 4.2 g/cm$^3$ or less.

This allows for a target material to be produced with a desired O and K composition throughout the entire structure.

(Supplementary description 2)

According to another aspect of the present disclosure, there is provided

a sputtering target material constituted from a sintered ceramics of an oxide containing potassium, sodium, niobium, and oxygen, wherein
the sputtering target material has a Vickers hardness of 30 or more and 200 or less and
an area-weighted mean grain size of 3.0 $\mu$m or more for a plurality of crystal grains observed on a sputtering surface.

This allows for a target material to be produced with high mechanical strength.

(Supplementary description 3)

According to yet another aspect of the present disclosure, there is provided

a sputtering target material constituted from a sintered ceramics of an oxide containing potassium, sodium, niobium, and oxygen, wherein
the sputtering target material has a density of 4.2 g/cm$^3$ or less,
a Vickers hardness of 30 or more and 200 or less, and
an area-weighted mean grain size of 3.0 $\mu$m or more for a plurality of crystal grains observed on a sputtering surface.

This allows for a target material to be produced with a desired O and K composition throughout the entire structure and with high mechanical strength.

(Supplementary description 4)

The target material of Supplementary description 2 or 3, preferably wherein
the area-weighted mean grain size is a value calculated using an area fraction method from an electron back scattered diffraction pattern (EBSD) image.

(Supplementary description 5)

The target material of any one of Supplementary descriptions 1 to 4, preferably wherein
the sputtering target material has a main surface with an area of 4500 mm$^2$ or more.

(Supplementary description 6)

The target material of any one of Supplementary descriptions 1 to 5, preferably wherein
the target material contains at least one element selected from copper and manganese as a dopant at a concentration of 0.1 at% or more and 2.0 at% or less.

(Supplementary description 7)

The target material of any one of Supplementary descriptions 1 to 6, preferably wherein
the plurality of crystal grains observed at the sputtering surface primarily include a plurality of crystal grains composed of an oxide containing sodium and niobium and a plurality of crystal grains composed of an oxide containing potassium and niobium.

(Supplementary description 8)

The target material of any one of Supplementary descriptions 1 to 7, preferably wherein
portions of high sodium content (sodium-rich portions) and portions of high potassium content (potassium-rich portions) are present (scattered) on the sputtering surface.

(Supplementary description 9)

The target material of any one of Supplementary descriptions 1 to 8, preferably wherein
the value of ([K]+[Na])/[Nb] is more than 1.0, where [K] is a molar quantity of potassium atoms contained in the sintered ceramics, [Na] is a molar quantity of sodium atoms contained in the sintered ceramics, and [Nb] is a molar quantity of niobium atoms contained in the sintered ceramics.

(Supplementary description 10)

According to yet another aspect of the present disclosure, there is provided

> a sputtering target including
> the sputtering target material of any one of Supplementary descriptions 1 to 9 and
> a backing plate bonded to the sputtering target material.

(Supplementary description 11)

According to yet another aspect of the present disclosure, there is provided

> a sputtering target material constituted from a sintered ceramics of an oxide containing potassium, sodium, niobium, and oxygen, wherein
> no crack formation is found in an observation of the sputtering target material after the sputtering target material is attached, via a bonding material, on top of a backing plate to prepare a sputtering target, the sputtering target is set in a RF plasma sputtering apparatus and subjected to a process for depositing a piezoelectric film containing potassium, sodium, niobium, and oxygen in a mixed gas atmosphere of argon gas and oxygen gas at an RF power density of 2.0 $W/cm^2$ or more, and the piezoelectric film is deposited to a cumulative deposition thickness of over 50 $\mu$m.

"No crack formation" means there is no cracking that would result in abnormal discharges when sputtering at the RF power density.

(Supplementary description 12)

According to yet another aspect of the present disclosure, there is provided

> a method for producing a sputtering target material constituted from a sintered ceramics of an oxide containing potassium, sodium, niobium, and oxygen, the method including:
>
> > (a) mixing a raw material powder including a compound containing sodium and a raw material powder including a compound containing niobium at a predetermined ratio and heating same in an oxygen-containing atmosphere to prepare a fired powder containing sodium and niobium;
> > (b) mixing a raw material powder including a compound containing potassium and a raw material powder including a compound containing niobium at a predetermined ratio and heating same in an oxygen-containing atmosphere to prepare a fired powder containing potassium and niobium;
> > (c) mixing the fired powder prepared in (a) and the fired powder prepared in (b) at a predetermined ratio and heating (calcinating) same in an oxygen-containing atmosphere to prepare a fired powder containing potassium, sodium, and niobium; and
> > (d) applying a predetermined pressure to the fired powder prepared in (c) to form a powder compact while also heating the powder compact to produce a sintered ceramics, wherein
>
> a temperature of heating in (a) is higher than a temperature of heating in (b).

(Supplementary description 13)

The production method of Supplementary description 12, preferably wherein
in (c), the fired powder prepared in (a), the fired powder prepared in (b), and a powder containing at least one element selected from copper and manganese are mixed at a predetermined ratio to prepare a fired powder containing, in addition to potassium, sodium and niobium, the at least one element selected from copper and manganese as a dopant.

(Supplementary description 14)

The production method of Supplementary description 12 or 13, preferably further including after (d), (e) applying a heat treatment to the sintered ceramics in an oxygen-containing atmosphere at a temperature of 500 °C or higher and 1100 °C or lower for one hour or more.

(Supplementary description 15)

The production method of any one of Supplementary descriptions 12 to 14, preferably wherein the temperature of heating in (a) is a temperature at which a mean size of primary particles in the fired powder containing sodium and niobium is larger than a mean size of primary particles in the fired powder containing potassium and niobium prepared in (b).

(Supplementary description 16)

The production method of Supplementary description 15, preferably wherein the mean size of primary particles in the fired powder containing sodium and niobium and the mean size of primary particles in the fired powder containing potassium and niobium are both values calculated, by reading, from a scanning electron microscope (SEM) image observed at 2000 to 5000 times magnification.

(Supplementary description 17)

The production method of any one of Supplementary descriptions 12 to 16, preferably wherein the temperature of heating in (a) is a temperature at which a mean size of primary particles in the fired powder containing sodium and niobium becomes 5.0 $\mu$m or more, more preferably 10.0 $\mu$m or more.

(Supplementary description 18)

The production method of any one of Supplementary descriptions 12 to 17, preferably wherein the temperature of heating in (a) is 1000 °C or higher.

(Supplementary description 19)

The production method of any one of Supplementary descriptions 12 to 18, preferably wherein in (b), the mixing ratio of the raw material powder including the compound containing potassium and the raw material powder including the compound containing niobium is adjusted such that a mean size of primary particles in the fired powder containing potassium and niobium becomes 3.0 $\mu$m or more, preferably 5.0 $\mu$m or more.

(Supplementary description 20)

The production method of Supplementary description 19, preferably wherein the mean size of primary particles in the fired powder containing potassium and niobium is a value calculated, by reading, from a scanning electron microscope (SEM) image observed at 2000 to 5000 times magnification.

(Supplementary description 21)

The production method of any one of Supplementary descriptions 12 to 20, preferably wherein in (b), the mixing ratio of the raw material powder including the compound containing potassium and the raw material powder including the compound containing niobium is adjusted such that the fired powder containing potassium and niobium has a potassium-rich composition.

(Supplementary description 22)

The production method of Supplementary description 21, preferably wherein in (b), the mixing ratio of the raw material powder including the compound containing potassium and the raw material powder including the compound containing niobium is adjusted such that a ratio (K/Nb) of a potassium composition to a niobium composition in the fired powder containing potassium and niobium becomes 1.005 or more.

(Supplementary description 23)

The production method of any one of Supplementary descriptions 12 to 22, preferably wherein in (c), the mixing is carried out under a condition in which a mean size of primary particles in a powder mixture prepared from mixing the fired powder prepared in (a) and the fired powder prepared in (b) becomes 3.0 μm or more, preferably 5.0 μm or more.

(Supplementary description 24)

The production method of any one of Supplementary descriptions 12 to 23, preferably wherein

in (c), a powder mixture prepared from mixing the fired powder prepared in (a) and the fired powder prepared in (b) is milled, and/or the fired powder containing potassium, sodium, and niobium is milled,
and the milling is carried out under a condition in which a mean size of primary particles in the powder mixture or the fired powder after the milling becomes 3.0 μm or more, preferably 5.0 μm or more.

(Supplementary description 25)

The production method of Supplementary description 23 or 24, preferably wherein the mean size of primary particles in the powder mixture or the fired powder is a value calculated, by reading, from a scanning electron microscope (SEM) image observed at 2000 to 5000 times magnification.

REFERENCE SIGNS LIST

10     Target material
10s    Sputtering surface

**Claims**

1. A sputtering target material comprising a sintered ceramics of an oxide containing potassium, sodium, niobium, and oxygen, wherein

   the sputtering target material has a density of 4.2 g/cm$^3$ or less,
   a Vickers hardness of 30 or more and 200 or less, and
   an area-weighted mean grain size of 3.0 μm or more for a plurality of crystal grains observed on a sputtering surface.

2. The sputtering target material according to claim 1, wherein
   the sputtering target material has a main surface with an area of 4500 mm$^2$ or more.

3. The sputtering target material according to claim 1, wherein
   the sputtering target material contains at least one element selected from copper and manganese as a dopant at a concentration of 0.1 at% or more and 2.0 at% or less.

4. The sputtering target material according to claim 1, wherein
   the plurality of crystal grains observed at the sputtering surface primarily include a plurality of crystal grains composed of an oxide containing sodium and niobium and a plurality of crystal grains composed of an oxide containing potassium and niobium.

5. The sputtering target material according to claim 1, wherein
   portions of high sodium content and portions of high potassium content are present on the sputtering surface.

6. The sputtering target material according to any one of claims 1 to 5, wherein
   a value of ([K]+[Na])/[Nb] is more than 1.0, where [K] is a molar quantity of potassium atoms contained in the sintered ceramics, [Na] is a molar quantity of sodium atoms contained in the sintered ceramics, and [Nb] is a molar quantity of niobium atoms contained in the sintered ceramics.

7. A method for producing a sputtering target material comprising a sintered ceramics of an oxide containing potassium, sodium, niobium, and oxygen, the method comprising:

(a) mixing a raw material powder comprising compound containing sodium and a raw material powder comprising a compound containing niobium at a predetermined ratio and heating same in an oxygen-containing atmosphere to prepare a fired powder containing sodium and niobium;

(b) mixing a raw material powder comprising a compound containing potassium and a raw material powder comprising a compound containing niobium at a predetermined ratio and heating same in an oxygen-containing atmosphere to prepare a fired powder containing potassium and niobium;

(c) mixing the fired powder prepared in (a) and the fired powder prepared in (b) at a predetermined ratio and calcinating in an oxygen-containing atmosphere to prepare a fired powder containing potassium, sodium, and niobium; and

(d) applying a predetermined pressure to the fired powder prepared in (c) to form a powder compact while also heating the powder compact to prepare a sintered ceramics, wherein

a temperature of heating in (a) is higher than a temperature of heating in (b).

8. The method for producing a sputtering target material according to claim 7, wherein
in (c), the fired powder prepared in (a), the fired powder prepared in (b), and a powder containing at least one element selected from copper and manganese are mixed at a predetermined ratio to prepare a fired powder containing, in addition to potassium, sodium and niobium, the at least one element selected from copper and manganese as a dopant.

9. The method for producing a sputtering target material according to claim 7, further comprising
after (d), (e) applying a heat treatment to the sintered ceramics in an oxygen-containing atmosphere at a temperature of 500 °C or higher and 1100 °C or lower for one hour or more.

10. The method for producing a sputtering target material according to claim 7, wherein
the temperature of heating in (a) is a temperature at which a mean size of primary particles in the fired powder containing sodium and niobium becomes larger than a mean size of primary particles in the fired powder containing potassium and niobium prepared in (b).

11. The method for producing a sputtering target material according to claim 7, wherein
the temperature of heating in (a) is a temperature at which a mean size of primary particles in the fired powder containing sodium and niobium becomes 5.0 $\mu$m or more.

12. The method for producing a sputtering target material according to claim 7, wherein
the temperature of heating in (a) is 1000 °C or higher.

13. The method for producing a sputtering target material according to claim 7, wherein
in (b), the mixing ratio of the raw material powder comprising the compound containing potassium and the raw material powder comprising the compound containing niobium is adjusted such that a mean size of primary particles in the fired powder containing potassium and niobium becomes 3.0 $\mu$m or more.

14. The method for producing a sputtering target material according to claim 7, wherein
in (b), the mixing ratio of the raw material powder comprising the compound containing potassium and the raw material powder comprising the compound containing niobium is adjusted such that the fired powder containing potassium and niobium has a potassium-rich composition.

15. The method for producing a sputtering target material according to claim 14, wherein
in (b), the mixing ratio of the raw material powder comprising the compound containing potassium and the raw material powder comprising the compound containing niobium is adjusted such that the ratio of potassium composition to niobium composition in the fired powder containing potassium and niobium becomes 1.005 or more.

16. The method for producing a sputtering target material according to claim 7, wherein
in (c), the mixing is carried out under a condition in which a mean size of primary particles in the powder mixture prepared from mixing the fired powder prepared in (a) and the fired powder prepared in (b) becomes 3.0 $\mu$m or more.

**17.** The method for producing a sputtering target material according to claim 7, wherein

in (c), the powder mixture prepared from mixing the fired powder prepared in (a) and the fired powder prepared in (b) is milled, and/or the fired powder containing potassium, sodium, and niobium is milled, and the milling is carried out under a condition in which a mean size of primary particles in the powder mixture or the fired powder after the milling becomes 3.0 $\mu$m or more.

# FIG. 1

# FIG. 2

# FIG. 3

(a)

FRACTURE SURFACE
OF SAMPLE 1

(b)

# FIG. 4

(a)

FRACTURE SURFACE
OF SAMPLE 21

(b)

## INTERNATIONAL SEARCH REPORT

| International application No. |
| --- |
| **PCT/JP2023/029023** |

| **A.** | **CLASSIFICATION OF SUBJECT MATTER** |
| --- | --- |

*C23C 14/34*(2006.01)i; *C04B 35/495*(2006.01)i; *H10N 30/076*(2023.01)i; *H10N 30/097*(2023.01)i; *H10N 30/853*(2023.01)i
FI:   C23C14/34 A; C04B35/495; H10N30/853; H10N30/076; H10N30/097

According to International Patent Classification (IPC) or to both national classification and IPC

| **B.** | **FIELDS SEARCHED** |
| --- | --- |

Minimum documentation searched (classification system followed by classification symbols)

    C23C14/34; C04B35/495; H10N30/076; H10N30/097; H10N30/853

Documentation searched other than minimum documentation to the extent that such documents are included in the fields searched

    Published examined utility model applications of Japan 1922-1996
    Published unexamined utility model applications of Japan 1971-2023
    Registered utility model specifications of Japan 1996-2023
    Published registered utility model applications of Japan 1994-2023

Electronic data base consulted during the international search (name of data base and, where practicable, search terms used)

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| A | JP 2020-183581 A (JX NIPPON MINING & METALS CORP.) 12 November 2020 (2020-11-12) entire text | 1-17 |
| A | JP 2021-027132 A (SUMITOMO CHEMICAL CO., LTD.) 22 February 2021 (2021-02-22) entire text | 1-17 |
| A | WO 2019/167657 A1 (JX NIPPON MINING & METALS CORP.) 06 September 2019 (2019-09-06) entire text | 1-17 |
| A | JP 2007-022854 A (TOYOTA JIDOSHA KABUSHIKI KAISHA) 01 February 2007 (2007-02-01) entire text | 1-17 |
| A | JP 2012-167316 A (HITACHI CABLE LTD.) 06 September 2012 (2012-09-06) entire text | 1-17 |
| P, A | WO 2022/224594 A1 (SUMITOMO CHEMICAL CO., LTD.) 27 October 2022 (2022-10-27) entire text | 1-17 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **19 October 2023** | **31 October 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/029023**

| Patent document cited in search report | | | Publication date (day/month/year) | Patent family member(s) | | | Publication date (day/month/year) |
|---|---|---|---|---|---|---|---|
| JP | 2020-183581 | A | 12 November 2020 | US 2020/0340096 A1 entire text<br>EP 3730668 A2<br>JP 2020-183574 A<br>JP 6756886 B1 | | | |
| JP | 2021-027132 | A | 22 February 2021 | US 2021/0036212 A1 entire text<br>EP 3772114 A1 | | | |
| WO | 2019/167657 | A1 | 06 September 2019 | US 2020/0370168 A1 entire text<br>EP 3660183 A1 | | | |
| JP | 2007-022854 | A | 01 February 2007 | (Family: none) | | | |
| JP | 2012-167316 | A | 06 September 2012 | (Family: none) | | | |
| WO | 2022/224594 | A1 | 27 October 2022 | JP 2022-165643 A<br><br>TW 202243296 A | | | |

## REFERENCES CITED IN THE DESCRIPTION

**Patent documents cited in the description**

- JP 2011146623 A